# EUROPEAN PATENT SPECIFICATION

(11) **EP 1 593 148 B1**
(45) Date of publication and mention of the grant of the patent: **29.04.2015**
(21) Application number: 04708039.5
(22) Date of filing: 04.02.2004
(51) Int. Cl.: B24B 37/30, B24B 37/32, B24B 49/16

(54) **SUBSTRATE HOLDING APPARATUS AND POLISHING APPARATUS**
SUBSTRATHALTEVORRICHTUNG UND POLIERVORRICHTUNG
APPAREIL A MAINTENIR LES SUBSTRATS ET APPAREIL A POLIR

(30) Priority: 10.02.2003 JP 2003033015; 06.06.2003 JP 2003163051; 06.06.2003 JP 2003163052
(43) Date of publication of application: 09.11.2005
(73) Proprietor: EBARA CORPORATION, Ohta-ku, Tokyo 144-8510 (JP)
(72) Inventor: TOGAWA, Tetsuji C/O Ebara Corporation, 1448510 (JP); YOSHIDA, Hiroshi C/O Ebara Corporation, 1448510 (JP); NABEYA, Osamu C/O Ebara Corporation, 1448510 (JP); FUKUSHIMA, Makoto C/O Ebara Corporation, 1448510 (JP); FUKAYA, Koichi C/O Ebara Corporation, 1448510 (JP)
(74) Representative: Emde, Eric
(86) International application number: PCT/JP2004/001143
(87) International publication number: WO 2004/070806

(56) References cited:
- WO-A1-99/02304
- WO-A2-02/07931
- JP-A- 10 270 538
- JP-A- 2000 127 026
- JP-A- 2002 198 337
- JP-A- 2002 198 339

## Description

### Technical Field

The present invention relates to a substrate holding apparatus for holding a substrate to be polished and pressing the substrate against a polishing surface, as per the preamble of claim 1. An example of such a substrate holding apparatus is disclosed by US 2002/0081955 A.

### Background Art

In recent years, semiconductor devices have become more integrated, and structures of semiconductor elements have become more complicated. Further, the number of layers in multilayer interconnections used for a logical system has been increased. Accordingly, irregularities on a surface of a semiconductor device become increased, so that step heights on the surface of the semiconductor device tend to be larger. This is because, in a manufacturing process of a semiconductor device, a thin film is formed on a semiconductor device, then micromachining processes, such as patterning or forming holes, are performed on the semiconductor device, and these processes are repeated many times to form subsequent thin films on the semiconductor device.

When the number of irregularities is increased on a surface of a semiconductor device, the following problems arise. The thickness of a film formed in a portion having a step is relatively small when a thin film is formed on a semiconductor device. An open circuit is caused by disconnection of interconnections, or a short circuit is caused by insufficient insulation between interconnection layers. As a result, good products cannot be obtained, and the yield tends to be reduced. Further, even if a semiconductor device initially works normally, reliability of the semiconductor device is lowered after a long-term use. At the time of exposure in a lithography process, if the irradiation surface has irregularities, then a lens unit in an exposure system is locally unfocused. Therefore, if the irregularities of the surface of the semiconductor device are increased, then it becomes problematic that it is difficult to form a fine pattern itself on the semiconductor device.

Accordingly, in a manufacturing process of a semiconductor device, it increasingly becomes important to planarize a surface of the semiconductor device. The most important one of the planarizing technologies is CMP (Chemical Mechanical Polishing). In the chemical mechanical polishing, with use of a polishing apparatus, while a polishing liquid containing abrasive particles such as silica (SiO₂) therein is supplied onto a polishing surface such as a polishing pad, a substrate such as a semiconductor wafer is brought into sliding contact with the polishing surface, so that the substrate is polished.

This type of polishing apparatus comprises a polishing table having a polishing surface constituted by a polishing pad, and a substrate holding apparatus, which is called as a top ring or a carrier head, for holding a semiconductor wafer. When a semiconductor wafer is polished with such a polishing apparatus, the semiconductor wafer is held and pressed against the polishing table under a predetermined pressure by the substrate holding apparatus. At this time, the polishing table and the substrate holding apparatus are moved relatively to each other to bring the semiconductor wafer into sliding contact with the polishing surface, so that the surface of the semiconductor wafer is polished to a flat mirror finish.

In such a polishing apparatus, if a relative pressing force between the semiconductor wafer being polished and the polishing surface of the polishing pad is not uniform over an entire surface of the semiconductor wafer, then the semiconductor wafer may insufficiently be polished or may excessively be polished at some portions depending on the pressing force applied to those portions of the semiconductor wafer. Therefore, it has been attempted to form a surface, for holding a semiconductor wafer, of a substrate holding apparatus by an elastic membrane made of an elastic material such as rubber and to supply fluid pressure such as air pressure to a backside surface of the elastic membrane to unformize pressing forces applied to the semiconductor wafer over an entire surface of the semiconductor wafer.

Further, the polishing pad is so elastic that pressing forces applied to a peripheral portion of the semiconductor wafer being polished become non-uniform, and hence only the peripheral portion of the semiconductor wafer may excessively be polished, which is referred to as "edge rounding". In order to prevent such edge rounding, there has been used a substrate holding apparatus in which a semiconductor wafer is held at its peripheral portion by a guide ring or a retainer ring, and the annular portion of the polishing surface that corresponds to the peripheral portion of the semiconductor wafer is pressed by the guide ring or retainer ring.

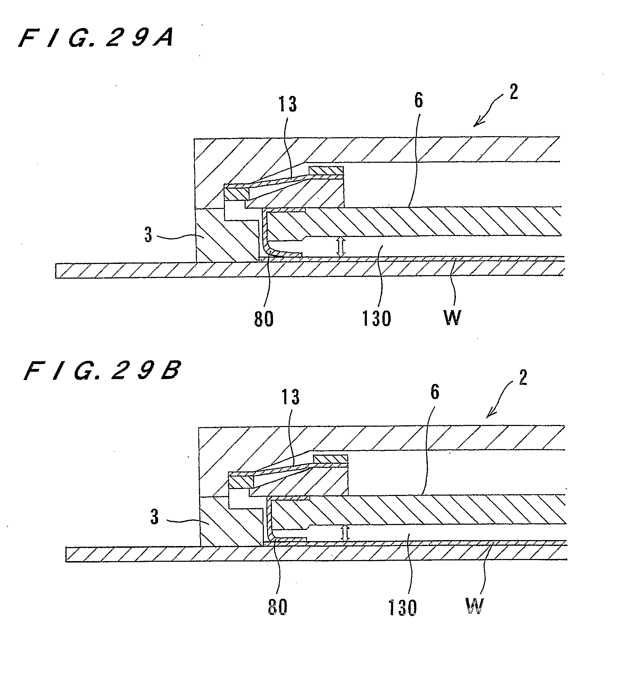

A conventional substrate holding apparatus will be described below with reference to FIGS. 29A and 29B. FIGS. 29A and 29B are fragmentary cross-sectional views showing a conventional substrate holding apparatus.

As shown in FIG. 29A, the substrate holding apparatus has a top ring body 2, a chucking plate 6 housed in the top ring body 2, and an elastic membrane 80 attached to the chucking plate 6. The elastic membrane 80 is disposed on an outer circumferential portion of the chucking plate 6, and is brought into contact with a circumferential edge of a semiconductor wafer W. An annular retainer ring 3 is fixed to a lower end of the top ring body 2, and presses a polishing surface near the outer circumferential edge of the semiconductor wafer W.

The chucking plate 6 is mounted on the top ring body 2 through an elastic pressurizing sheet 13. The chucking plate 6 and the elastic membrane 80 are vertically moved in a certain range with respect to the top ring body 2 and the retainer ring 3 by a fluid pressure. The substrate holding apparatus having such a structure is referred to as a so-called floating-type substrate holding apparatus. A pressure chamber 130 is defined by the elastic membrane 80, a lower surface of the chucking plate 6, and an upper surface of the semiconductor wafer W. A pressurized fluid is supplied into the pressure chamber 130, thereby lifting the chucking plate 6 and simultaneously pressing the semiconductor wafer W against the polishing surface. In this state, a polishing liquid is supplied onto the polishing surface, and a top ring (the substrate holding apparatus) and the polishing surface are rotated independently of each other, thus polishing a lower surface of the semiconductor wafer W to a flat finish.

After the polishing process is finished, the semiconductor wafer W is attracted under vacuum and held by the top ring. The top ring is moved to a transfer position while holding the semiconductor wafer W, and then a fluid (e.g., a pressurized fluid or a mixture of nitrogen and pure water) is ejected from a lower portion of the chucking plate 6 so as to release the semiconductor wafer W.

However, in the conventional floating-type substrate holding apparatus described above, when the chucking plate 6 is moved upwardly for pressing the semiconductor wafer W, the elastic membrane 80, which is held in contact with the outer circumferential edge of the semiconductor wafer W, is lifted by the chucking plate 6, thus causing an outer circumferential edge of the elastic membrane 80 to be brought out of contact with the semiconductor wafer W. Consequently, a pressing force applied to the semiconductor wafer W is locally changed at the outer circumferential edge of the semiconductor wafer W. As a result, a polishing rate is lowered at the outer circumferential edge of the semiconductor wafer W and is increased at a region located radially inwardly of the outer circumferential edge of the semiconductor wafer W.

As a hardness of the elastic membrane becomes higher, such a problem becomes worse. Therefore, it has been attempted to use an elastic membrane having a low hardness so that a contact area between the elastic membrane and the semiconductor wafer is kept constant. However, in the floating-type substrate holding apparatus, the semiconductor wafer W is polished while the retainer ring 3 is held in sliding contact with the polishing surface. Accordingly, the retainer ring 3 tends to wear with time, resulting in a reduction in a distance between the semiconductor wafer W and the chucking plate 6 (see FIG. 29B). Consequently, the pressing force applied to the outer circumferential edge of the semiconductor wafer W is changed, and hence the polishing rate is changed at the outer circumferential edge of the semiconductor wafer W, thus causing a change in a polishing profile. Further, because of such a drawback, it is necessary to replace the worn retainer ring at an early stage, and hence a lifetime of the retainer ring is limited to a short period.

In addition to the above problem, the conventional substrate holding apparatus has another problem as follows: When the polishing process is to be started, the pressurized fluid is supplied to the pressure chamber while the elastic membrane and the semiconductor wafer may not be sufficiently held in close contact with each other. As a result, the pressurized fluid is liable to leak from a gap between the elastic membrane and the semiconductor wafer.

Further, in a process of releasing the semiconductor wafer from the top ring, the following problem arises: If a film of nitride or the like is formed on the backside surface (upper surface) of the semiconductor wafer, then the elastic membrane and the semiconductor wafer adhere to each other. Therefore, when releasing the semiconductor wafer, the elastic membrane may not be brought out of contact with the semiconductor wafer. In this state, if a pressurized fluid is continuously ejected to the semiconductor wafer, the elastic membrane is stretched while keeping contact with the semiconductor wafer. As a result, the semiconductor wafer is deformed, or broken at worst, due to a fluid pressure.

Furthermore, still another problem arises in the conventional substrate holding apparatus as follows: The pressure chamber constituted by the elastic membrane is deformed due to a fluid pressure. Therefore, the elastic membrane is locally brought out of contact with the semiconductor wafer as the pressurized fluid is supplied to the pressure chamber. Consequently, a pressing force applied to the semiconductor wafer is locally lowered, and hence a uniform polishing rate cannot be obtained over the entire polished surface of the semiconductor wafer.

As a hardness of the elastic membrane becomes higher, such a problem becomes worse. Therefore, as already described, it has been attempted to use an elastic membrane having a low hardness so that a contact area between the elastic membrane and the semiconductor wafer is kept constant. However, because the elastic membrane having a low hardness has a low mechanical strength, the elastic membrane tends to suffer cracking, and is thus required to be replaced frequently.

Further, attention is drawn to WO 02 07931, which discloses a carrier head with a flexible membrane. The carrier head has a retainer ring, a movable member which is movable perpendicularly to a polishing surface, and an elastic membrane for defining a plurality of pressure chambers. The retainer ring and the elastic membrane are both connected to the movable member to move therewith.

### Disclosure of Invention

The present invention has been made in view of the above drawbacks. According to the present invention, a substrate holding apparatus as set forth in claim 1, a polishing apparatus as set forth in claim 28 and a method of polishing a substrate as set forth in claim 29 are provided.

### Brief Description of Drawings

FIG. 1 is a cross-sectional view showing an entire structure of a polishing apparatus having a substrate holding apparatus;
FIG. 2 is a vertical cross-sectional view showing a top ring incorporated in the substrate holding apparatus ;
FIGS. 3A through 3C are enlarged cross-sectional views showing an intermediate air bag shown in FIG. 2;
FIG. 4A is a cross-sectional view showing an entire structure of an edge membrane;
FIGS. 4B and 4C are fragmentary cross-sectional views showing the substrate holding apparatus shown in FIG. 2;
FIGS. 5A and 5B are fragmentary cross-sectional views showing a substrate holding apparatus;
FIG. 6A is a fragmentary cross-sectional view showing a substrate holding apparatus;
FIG. 6B is a fragmentary cross-sectional view showing another structure of an edge membrane;
FIG. 7 is a fragmentary cross-sectional view showing a substrate holding apparatus;
FIG. 8A is a cross-sectional view showing an edge membrane;
FIG. 8B is a cross-sectional view showing another structure of an edge membrane;
FIG. 9A is a cross-sectional view showing an edge membrane;
FIG. 9B is a reference view illustrating a stretchability of the edge membrane;
FIG. 10A is a cross-sectional view showing an edge membrane ;
FIGS. 10B through 10E are cross-sectional views each showing another structure of an edge membrane ;
FIGS. 11A and 11B are fragmentary cross-sectional views showing a substrate holding apparatus ;
FIG. 12A is a cross-sectional view showing a part of a substrate holding apparatus;
FIG. 12B is a view showing a part of the substrate holding apparatus as viewed in the direction indicated by the arrow A in FIG. 12A;
FIG. 13 is a view showing an intermediate membrane as viewed in the direction indicated by the arrow B in FIG. 12A;
FIG. 14 is a perspective view showing an intermediate air bag incorporated in the substrate holding apparatus ;
FIG. 15 is a rear view showing an elastic member incorporated in a substrate holding apparatus;
FIG. 16 is a rear view showing a first example of an elastic member incorporated in a substrate holding apparatus;
FIG. 17 is a rear view showing a second example of an elastic member incorporated in the substrate holding apparatus;
FIG. 18 is a rear view showing a third example of an elastic member incorporated in the substrate holding apparatus;
FIG. 19 is a rear view showing a fourth example of an elastic member incorporated in the substrate holding apparatus;
FIG. 20 is a cross-sectional view showing an entire structure of a polishing apparatus having a substrate holding apparatus;
FIG. 21 is a vertical cross-sectional view showing a top ring;
FIG. 22A is a view showing a part of the top ring ;
FIG. 22B is a view showing the state in which a fluid is supplied to pressure chambers;
FIG. 23A is a view showing a part of a top ring ;
FIG. 23B is a view showing the state in which a fluid is supplied to pressure chambers;
FIG. 24A is a view showing a part of a top ring ;
FIG. 24B is a view showing the state in which a fluid is supplied to pressure chambers;
FIG. 25A is a view showing a part of a top ring ;
FIG. 25B is a view showing the state in which a fluid is supplied to pressure chambers;
FIG. 26A is a view showing a part of a substrate holding apparatus;
FIG. 26B is a view showing the state in which a fluid is supplied to pressure chambers;
FIG. 27A is an enlarged cross-sectional view showing a part of a first example of a top ring;
FIG. 27B is an enlarged cross-sectional view showing a part of a second example of a top ring;
FIG. 27C is an enlarged cross-sectional view showing a part of a third example of a top ring;
FIG. 28A is an enlarged cross-sectional view showing a part of a first example of a top ring;
FIG. 28B is an enlarged cross-sectional view showing a part of a second example of a top ring;
FIG. 28C is an enlarged cross-sectional view showing a part of a third example of a top ring; and
FIGS. 29A and 29B are fragmentary cross-sectional views showing a conventional substrate holding apparatus.

### Best Mode for Carrying Out the Invention

A substrate holding apparatus and a polishing apparatus will be described in detail below with reference to the drawings.

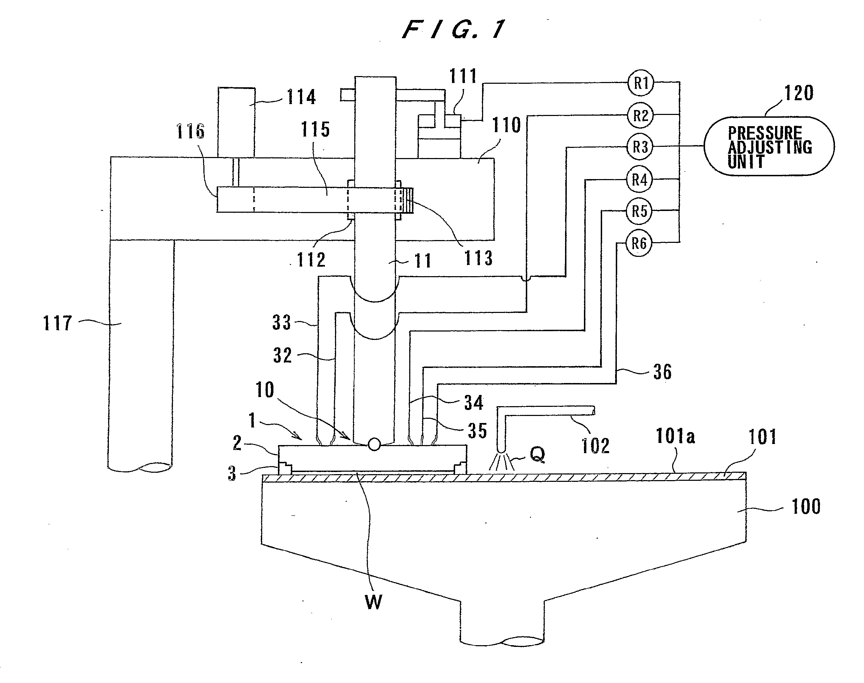

FIG. 1 is a cross-sectional view showing an entire structure of a polishing apparatus having a substrate holding apparatus. The substrate holding apparatus serves to hold a substrate such as a semiconductor wafer to be polished and to press the substrate against a polishing surface on a polishing table. As shown in FIG. 1, a polishing table 100 having a polishing pad 101 attached on an upper surface thereof is provided underneath a top ring 1 constituting a substrate holding apparatus. A polishing liquid supply nozzle 102 is provided above the polishing table 100, and a polishing liquid Q is supplied onto a polishing surface 101a of the polishing pad 101 placed on the polishing table 100 from the polishing liquid supply nozzle 102.

Various kinds of polishing pads are available on the market. For example, some of these are SUBA800, IC-1000, and IC-1000/SUBA100 (two-layer cloth) manufactured by Rodel Inc., and Surfin xxx-5 and Surfin 000 manufactured by Fujimi Inc. SUBA800, Surfin xxx-5, and Surfin 000 are nonwoven fabrics bonded by urethane resin, and IC-1000 is made of rigid foam polyurethane (single-layer). Foam polyurethane is porous and has a large number of fine recesses or holes formed in its surface.

The top ring 1 is connected to a top ring drive shaft 11 by a universal joint 10, and the top ring drive shaft 11 is coupled to a top ring air cylinder 111 fixed to a top ring head 110. The top ring air cylinder 111 operates to move the top ring drive shaft 11 vertically to thereby lift and lower the top ring 1 as a whole and to press a retainer ring 3 fixed to a lower end of a top ring body 2 against the polishing table 100. The top ring air cylinder 111 is connected to a pressure adjusting unit 120 via a regulator R1. The pressure adjusting unit 120 serves to adjust a pressure by supplying a pressurized fluid such as pressurized air from a compressed air source (not shown) or developing a vacuum with a pump (not shown) or the like. The pressure adjusting unit 120 can adjust a fluid pressure of the pressurized fluid to be supplied to the top ring air cylinder 111 with the regulator R1. Thus, it is possible to adjust a pressing force of the retainer ring 3 which presses the polishing pad 101.

The top ring drive shaft 11 is connected to a rotary sleeve 112 by a key (not shown). The rotary sleeve 112 has a timing pulley 113 fixedly disposed on a peripheral portion thereof. A top ring motor 114 is fixed to the top ring head 110, and the timing pulley 113 is coupled to a timing pulley 116 mounted on the top ring motor 114 via a timing belt 115. Therefore, when the top ring motor 114 is energized for rotation, the rotary sleeve 112 and the top ring drive shaft 11 are rotated in unison with each other via the timing pulley 116, the timing belt 115, and the timing pulley 113 to thereby rotate the top ring 1. The top ring head 110 is supported by a top ring head shaft 117 which is rotatably supported by a frame (not shown).

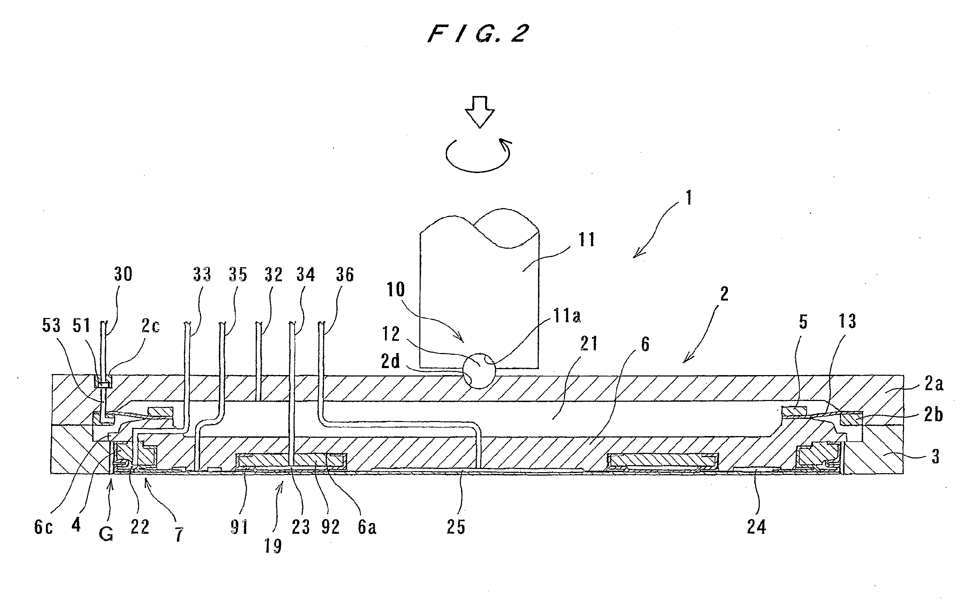

The top ring 1 serving as the substrate holding apparatus will be described below in detail. FIG. 2 is a vertical cross-sectional view showing the top ring 1 .

As shown in FIG. 2, the top ring 1 serving as the substrate holding apparatus comprises the cylinder-vessel-shaped top ring body 2 having a housing space formed therein, and the annular retainer ring 3 fixed to the lower end of the top ring body 2. The top ring body 2 is made of a highly strong and rigid material such as metal or ceramics. The retainer ring 3 is made of highly rigid resin, ceramics, or the like.

The top ring body 2 comprises a cylinder-vessel-shaped housing 2a, an annular pressurizing sheet support 2b fitted into a cylindrical portion of the housing 2a, and an annular seal 2c fitted into a groove formed in a circumferential edge of an upper surface of the housing 2a. The retainer ring 3 is fixed to a lower end of the housing 2a of the top ring body 2. The retainer ring 3 has a lower portion projecting radially inwardly. The retainer ring 3 may be formed integrally with the top ring body 2.

The top ring drive shaft 11 is disposed above the central portion of the housing 2a of the top ring body 2, and the top ring body 2 is coupled to the top ring drive shaft 11 by the universal joint 10. The universal joint 10 has a spherical bearing mechanism by which the top ring body 2 and the top ring drive shaft 11 are tiltable with respect to each other, and a rotation transmitting mechanism for transmitting the rotation of the top ring drive shaft 11 to the top ring body 2. The spherical bearing mechanism and the rotation transmitting mechanism transmit a pressing force and a rotating force from the top ring drive shaft 11 to the top ring body 2 while allowing the top ring body 2 and the top ring drive shaft 11 to be tilted with respect to each other.

The spherical bearing mechanism comprises a hemispherical concave recess 11a defined centrally in the lower surface of the top ring drive shaft 11, a hemispherical concave recess 2d defined centrally in the upper surface of the housing 2a, and a bearing ball 12 made of a highly hard material such as ceramics and interposed between the concave recesses 11a and 2d. The rotation transmitting mechanism comprises drive pins (not shown) fixed to the top ring drive shaft 11, and driven pins (not shown) fixed to the housing 2a. Even if the top ring body 2 is tilted with respect to the top ring drive shaft 11, the drive pins and the driven pins remain in engagement with each other while contact points are displaced because the drive pin and the driven pin are vertically movable relatively to each other. Thus, the rotation transmitting mechanism reliably transmits rotational torque of the top ring drive shaft 11 to the top ring body 2.

The top ring body 2 and the retainer ring 3 integrally fixed to the top ring body 2 define a housing space therein. An annular holder ring 5 and a disk-shaped chucking plate 6 serving as a vertically movable member are disposed in the housing space. The chucking plate 6 is vertically movable within the housing space formed in the top ring body 2. The chucking plate 6 may be made of metal. However, when a thickness of a thin film formed on a surface of a semiconductor wafer is measured by a method using eddy current in a state such that the semiconductor wafer to be polished is held by the top ring 1, the chucking plate 6 should preferably be made of a nonmagnetic material, e.g., an insulating material such as PPS, PEEK, fluororesin, or ceramics.

A pressurizing sheet 13 comprising an elastic membrane is disposed between the holder ring 5 and the top ring body 2. The pressurizing sheet 13 has a radially outer edge clamped between the housing 2a and the pressurizing sheet support 2b of the top ring body 2, and a radially inner edge clamped between the holder ring 5 and the chucking plate 6. The top ring body 2, the chucking plate 6, the holder ring 5, and the pressurizing sheet 13 jointly define a pressure chamber 21 in the top ring body 2. As shown in FIG. 2, the pressure chamber 21 communicates with a fluid passage 32 comprising a tube, a connector, and the like. The pressure chamber 21 is connected to the pressure adjusting unit 120 via a regulator R2 provided on the fluid passage 32. The pressurizing sheet 13 is made of a highly strong and durable rubber material such as ethylene propylene rubber (EPDM), polyurethane rubber, or silicone rubber.

In the case where the pressurizing sheet 13 is made of an elastic material such as rubber, if the pressurizing sheet 13 is fixedly clamped between the retainer ring 3 and the top ring body 2, then a desired horizontal surface cannot be maintained on the lower surface of the retainer ring 3 because of elastic deformation of the pressurizing sheet 13 as an elastic material. In order to prevent such a drawback, the pressurizing sheet 13 is clamped between the housing 2a of the top ring body 2 and the pressurizing sheet support 2b provided as a separate member in the present embodiment. The retainer ring 3 may vertically be movable with respect to the top ring body 2, or the retainer ring 3 may have a structure capable of pressing the polishing surface 101a independently of the top ring body 2. In such cases, the pressurizing sheet 13 is not necessarily fixed in the aforementioned manner.

An annular edge membrane (elastic member) 7 is mounted on the outer circumferential edge of the chucking plate 6, and is brought into contact with the outer circumferential edge of the semiconductor wafer W held by the top ring 1. An upper end of the edge membrane 7 is clamped between the outer circumferential edge of the chucking plate 6 and an annular edge ring 4, so that the edge membrane 7 is attached to the chucking plate 6.

The edge membrane 7 has a pressure chamber 22 formed therein which communicates with a fluid passage 33 comprising a tube, a connector, and the like. The pressure chamber 22 is connected to the pressure adjusting unit 120 via a regulator R3 provided on the fluid passage 33. The edge membrane 7 is made of a highly strong and durable rubber material such as ethylene propylene rubber (EPDM), polyurethane rubber, silicone rubber, as with the pressurizing sheet 13. The rubber material of the edge membrane 7 should preferably have a hardness (duro) ranging from 20 to 60.

When the semiconductor wafer W is polished, the semiconductor wafer W is rotated by the rotation of the top ring 1. The edge membrane 7 has a small contact area with the semiconductor wafer W, and is thus liable to fail to transmit a sufficient rotational torque to the semiconductor wafer W. Accordingly, an annular intermediate air bag 19, to be brought into close contact with the semiconductor wafer W, is fixed to the lower surface of the chucking plate 6, so that a sufficient torque is transmitted to the semiconductor wafer W by the intermediate air bag 19. The intermediate air bag 19 is disposed radially inwardly of the edge membrane 7, and is brought into close contact with the semiconductor wafer W with a contact area large enough to transmit a sufficient torque to the semiconductor wafer W.

The intermediate air bag 19 comprises an elastic membrane 91 brought into contact with the upper surface of the semiconductor wafer W, and an air bag holder 92 for detachably holding the elastic membrane 91 in position. An annular groove 6a is formed in the lower surface of the chucking plate 6, and the air bag holder 92 is fixedly mounted in the annular groove 6a by screws (not shown). An upper end of the elastic membrane 91 constituting the intermediate air bag 19 is cramped between the annular groove 6a and the air bag holder 92, so that the elastic membrane 91 is detachably mounted on the lower surface of the chucking plate 6.

The intermediate air bag 19 has a pressure chamber 23 defined therein by the elastic membrane 91 and the air bag holder 92. The pressure chamber 23 communicates with a fluid passage 34 comprising a tube, a connector, and the like. The pressure chamber 23 is connected to the pressure adjusting unit 120 via a regulator R4 provided on the fluid passage 34. The elastic membrane 91 is made of a highly strong and durable rubber material such as ethylene propylene rubber (EPDM), polyurethane rubber, silicone rubber, as with the pressurizing sheet 13.

An annular space defined by the edge membrane 7, the intermediate air bag 19, the semiconductor wafer W, and the chucking plate 6 serves as a pressure chamber 24. The pressure chamber 24 communicates with a fluid passage 35 comprising a tube, a connector, and the like. The pressure chamber 24 is connected to the pressure adjusting unit 120 via a regulator R5 provided on the fluid passage 35.

A circular space defined by the intermediate air bag 19, the semiconductor wafer W, and the chucking plate 6 serves as a pressure chamber 25. The pressure chamber 25 communicates with a fluid passage 36 comprising a tube, a connector, and the like. The pressure chamber 25 is connected to the pressure adjusting unit 120 via a regulator R6 provided on the fluid passage 36. The fluid passages 32, 33, 34, 35 and 36 are connected to the regulators R2 through R6, respectively, through a rotary joint (not shown) disposed on an upper end of the top ring head 110.

A cleaning liquid passage 51 in the form of an annular groove is formed in the seal 2c of the top ring body 2 near the outer circumferential edge of the upper surface of the housing 2a. The cleaning liquid passage 51 communicates with a fluid passage 30 and is supplied with a cleaning liquid such as pure water through the fluid passage 30. A plurality of communication holes 53 extend from the cleaning liquid passage 51 and pass through the housing 2a and the pressurizing sheet support 2b. The communication holes 53 communicate with a small gap G between the outer circumferential surface of the edge membrane 7 and the inner circumferential surface of the retainer ring 3.

Since the small gap G is formed between the outer circumferential surface of the edge membrane 7 and the retainer ring 3, members including the holder ring 5, the chucking plate 6, the edge membrane 7 mounted on the chucking plate 6 are vertically movable with respect to the top ring body 2 and the retainer ring 3 in a floating manner. The chucking plate 6 has a plurality of projections 6c projecting radially outwardly from the outer circumferential edge thereof. When the projections 6c engage with an upper surface of the inwardly projecting portion of the retainer ring 3, downward movement of the members including the chucking plate 6 is restricted to a certain position.

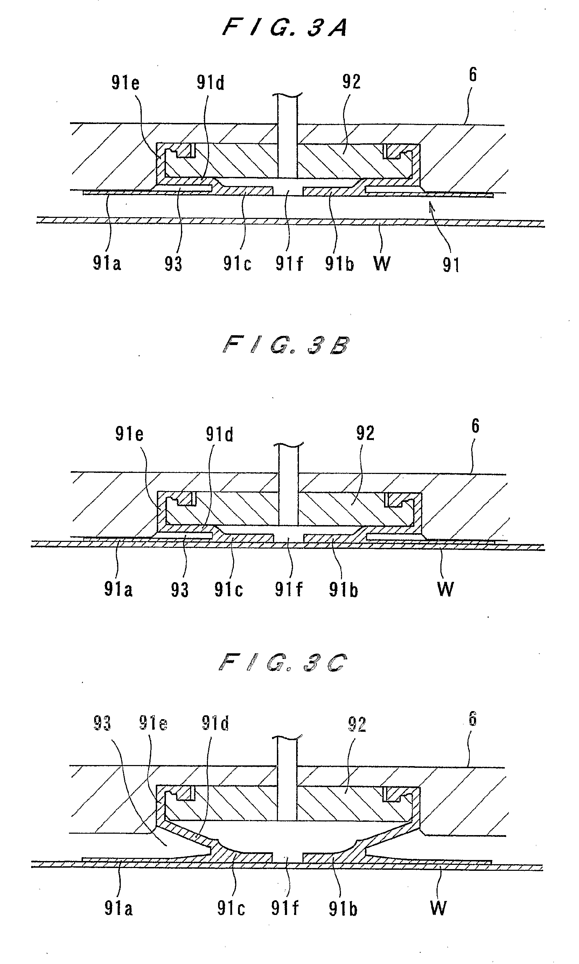

The intermediate air bag 19 will be described in detail below with reference to FIGS. 3A through 3C. FIGS. 3A through 3C are enlarged cross-sectional views showing the intermediate air bag shown in FIG. 2.

As shown in FIG. 3A, the elastic membrane 91 of the intermediate air bag 19 has an intermediate contact portion 91b having flanges 91a projecting outwardly, extending portions 91d extending outwardly from base portions 91c of the flanges 91a to form grooves 93 between the extending portions 91d and the flanges 91a, and connecting portions 91e connected to the chucking plate 6 by the air bag holder 92. The extending portions 91d extend outwardly from the base portions 91c of the flanges 91a to positions inward of tips of the flanges 91a, and the connecting portions 91e extend upwardly from outward ends of the extending portions 91d. The flanges 91a, the intermediate contact portion 91b, the connecting portions 91e, and the extending portions 91d are integrally formed with each other and are made of the same material. An open mouth 91f is formed in a central portion of the intermediate contact portion 91b.

With this structure, in a case where the chucking plate 6 is lifted for polishing after the semiconductor wafer W is brought into close contact with the intermediate contact portion 91b of the intermediate air bag 19 (see FIG. 3B), upward forces by the connecting portions 91e are converted into forces in horizontal or oblique directions by the extending portions 91d, and the converted forces are applied to the base portions 91c of the flanges 91a (see FIG. 3C). Therefore, upward forces applied to the base portions 91c of the flanges 91a can be made extremely small, so that excessive upward forces are not applied to the contact portion 91b. Accordingly, a vacuum is not formed near the base portions 91c, so that a uniform polishing rate can be achieved over the entire surface of the intermediate contact portion 91b except the flanges 91a. In this case, the thickness of the connecting portions 91e or the length of the flanges 91a may be varied between the connecting portion disposed radially inwardly and the connecting portion disposed radially outwardly. Further, the length of the extending portions 91d may be varied between the extending portion disposed radially inwardly and the extending portion disposed radially outwardly. Furthermore, the thickness of the flanges 91a may be varied according to the type of a film formed on the semiconductor wafer to be polished or the type of the polishing pad. When a resistance or a polishing torque transmitted to the semiconductor wafer is large, the thickness of the flanges 91a should preferably be made larger in order to prevent torsion of the flanges 91a.

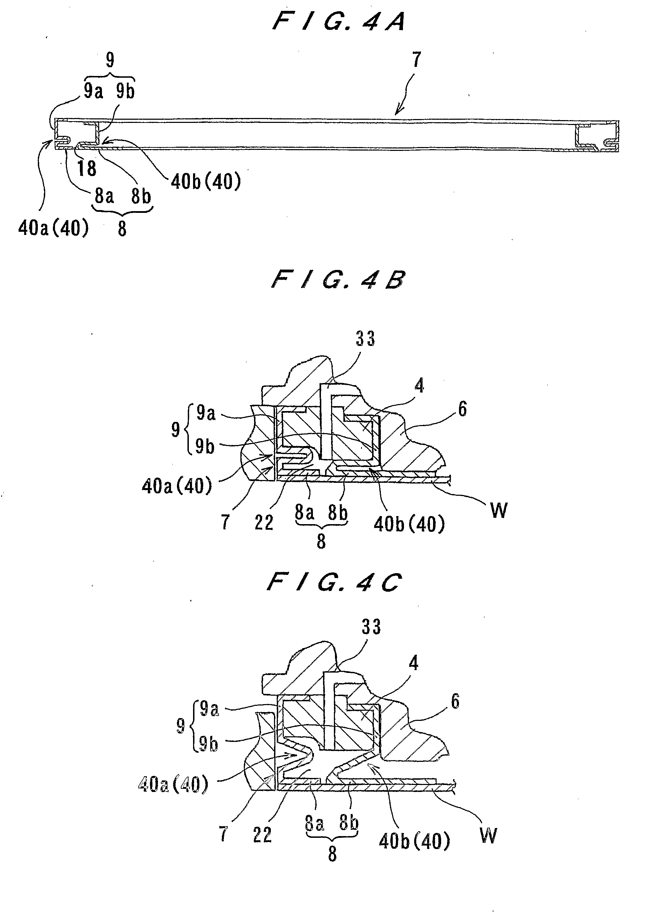

The edge membrane 7 according to the present embodiment will be described in detail below with reference to FIGS. 4A through 4C. FIG. 4A is a cross-sectional view showing an entire structure of the edge membrane, and FIGS. 4B and 4C are fragmentary cross-sectional views showing the substrate holding apparatus shown in FIG. 2.

The edge membrane (elastic member) 7 according to the present embodiment comprises an annular contact portion 8 which is brought into contact with the outer circumferential edge of the semiconductor wafer W, and an annular circumferential wall 9 extending upwardly from the contact portion 8 and connected to the chucking plate 6. The circumferential wall 9 comprises an outer circumferential wall 9a, and an inner circumferential wall 9b disposed radially inwardly of the outer circumferential wall 9a. The contact portion 8 has a shape extending radially inwardly from the circumferential wall 9 (i.e., the outer circumferential wall 9a and the inner circumferential wall 9b). The contact portion 8 has a circumferentially extending slit 18 positioned between the outer circumferential wall 9a and the inner circumferential wall 9b. Specifically, the slit 18 divides the contact portion 8 into an outer contact portion 8a and an inner contact portion 8b at a position between the outer circumferential wall 9a and the inner circumferential wall 9b.

As shown in FIGS. 4B and 4C, the outer circumferential wall 9a and the inner circumferential wall 9b extend upwardly along the outer and inner circumferential surfaces of the annular edge ring 4, respectively. Upper ends of the outer circumferential wall 9a and the inner circumferential wall 9b are clamped between the chucking plate 6 and the upper surface of the edge ring 4, respectively. The edge ring 4 is fastened to the chucking plate 6 by screws (not shown), so that the edge membrane 7 is detachably attached to the chucking plate 6. The fluid passage 33 extends vertically through the edge ring 4 and opens at the lower surface of the edge ring 4. Therefore, the annular pressure chamber 22 defined by the edge ring 4, the edge membrane 7, and the semiconductor wafer W communicates with the fluid passage 33, and is connected to the pressure adjusting unit 120 through the fluid passage 33 and the regulator R3.

The circumferential wall 9 has a stretchable and contractible portion 40 which is stretchable and contractible vertically, i.e., substantially perpendicularly to the semiconductor wafer W. More specifically, the outer circumferential wall 9a constituting the circumferential wall 9 has a stretchable and contractible portion 40a which is stretchable and contractible vertically. The stretchable and contractible portion 40a has a structure such that a portion of the outer circumferential wall 9a is folded inwardly and further folded outwardly to form a folded-back portion extending along the circumferential direction. The stretchable and contractible portion 40a is positioned near the outer contact portion 8a and is positioned below the edge ring 4. The inner circumferential wall 9b constituting the circumferential wall 9 also has a stretchable and contractible portion 40b which is stretchable and contractible vertically. The stretchable and contractible portion 40b has a structure such that a portion of the inner circumferential wall 9b near a lower end thereof is folded inwardly along the circumferential direction. Since the stretchable and contractible portions 40a, 40b are provided in the outer circumferential wall 9a and the inner circumferential wall 9b, respectively, the outer circumferential wall 9a and the inner circumferential wall 9b can largely be stretched and contracted while the contact portion 8 (i.e., the outer contact portion 8a and the inner contact portion 8b) is kept in shape. Therefore, as shown in FIG. 4C, when the chucking plate 6 is moved upwardly, the stretchable and contractible portions 40a, 40b are stretched so as to follow the movement of the chucking plate 6, thus allowing a contact area between the edge membrane 7 and the semiconductor wafer W to be kept constant.

The pressure chamber 21 above the chucking plate 6 and the pressure chambers 22, 23, 24 and 25 are supplied with pressurized fluid such as pressurized air, or atmospheric pressure or vacuum is produced in the pressure chambers 21, 22, 23, 24 and 25, through the fluid passages 32, 33, 34, 35 and 36 connected to the respective pressure chambers. Specifically, the regulators R2 through R6 provided respectively on the fluid passages 32, 33, 34, 35 and 36 can respectively regulate the pressures of the pressurized fluids supplied to the respective pressure chambers 21, 22, 23, 24 and 25. Thus, it is possible to independently control the pressures in the pressure chambers 21, 22, 23, 24 and 25, or independently produce atmospheric pressure or vacuum in the pressure chambers 21, 22, 23, 24 and 25.

As described above, the edge membrane 7 has the contact portion 8 (the inner contact portion 8b) extending radially inwardly on the lower end thereof, and the intermediate air bag 19 has the flange 91a on the lower end thereof. The contact portion 8 (the inner contact portion 8b) and the flange 91a are brought into intimate contact with the semiconductor wafer W by a pressurized fluid supplied to the pressure chambers 22, 23 and 24. Therefore, the pressurized fluid in the pressure chambers 22, 23 and 24 does not flow under the lower surfaces of the edge membrane 7 and the intermediate air bag 19. Specifically, the contact portion 8 and the flange 91a are pressed against the semiconductor wafer W by the pressurized fluid, and hence the edge membrane 7 and the intermediate air bag 19 are kept in intimate contact with the semiconductor wafer W. Therefore, it is possible to stably control the pressure in each of the pressure chambers 22, 23 and 24.

In this case, the pressurized fluid supplied to the pressure chambers 22, 23, 24 and 25, or atmospheric air supplied to the above pressure chambers when producing the atmospheric pressure therein may independently be controlled in temperature. With such a structure, it is possible to directly control the temperature of a workpiece such as a semiconductor wafer from the backside of the surface to be polished. Particularly, when the temperatures of the respective pressure chambers are independently controlled, a rate of chemical reaction can be controlled in the chemical polishing process of CMP.

Next, operation of the top ring 1 thus constructed will be described in detail.

In the polishing apparatus having the above structure, when a semiconductor wafer W is to be transferred to the polishing apparatus, the top ring 1 as a whole is moved to a transfer position where the semiconductor wafer W is transferred. In the case where the semiconductor wafer W has a diameter of 200 mm, the pressure adjusting unit 120 communicates with the pressure chamber 23 through the fluid passage 34. In the case where the semiconductor wafer W has a diameter of 300 mm, the pressure adjusting unit 120 communicates with the pressure chamber 24 through the fluid passage 35. Then, the pressure chamber 23 or 24 is evacuated by the pressure adjusting unit 120, so that the semiconductor wafer W is attracted under vacuum to the lower end of the top ring 1 by suction effect of the pressure chambers 23 or 24. With the semiconductor wafer W attracted to the top ring 1, the top ring 1 as a whole is moved to a position above the polishing table 100 having the polishing surface 101a on the polishing pad 101. The outer circumferential edge of the semiconductor wafer W is held by the retainer ring 3, so that the semiconductor wafer W is not removed from the top ring 1, or the semiconductor wafer W is not slid.

Thereafter, the attraction of the semiconductor wafer W by the pressure chambers 23 or 24 is stopped. About at the same time, the top ring air cylinder 111 connected to the top ring drive shaft 11 is actuated to press the retainer ring 3 fixed to the lower end of the top ring 1 against the polishing surface 101a of the polishing table 100 under a predetermined pressure. Then, the pressurized fluid is supplied to the pressure chamber 21 so as to move the chucking plate 6 downwardly, thereby pressing the edge membrane 7 and the intermediate air bag 19 against the semiconductor wafer W. In this manner, the lower surfaces of the edge membrane 7 and the intermediate air bag 19 can be brought into intimate contact with the upper surface of the semiconductor wafer W. In such a state, the pressurized fluids having respective pressures are supplied respectively to the pressure chambers 22, 23, 24 and 25, so that the chucking plate 6 is moved upwardly and simultaneously the semiconductor wafer W is pressed against the polishing surface 101a of the polishing table 100. At this time, the stretchable and contractible portions 40a, 40b provided in the edge membrane 7 are stretched so as to follow the upward movement of the chucking plate 6. Therefore, the contact area between the lower surface, i.e. the contact portion 8, of the edge membrane 7 and the outer circumferential edge of the semiconductor wafer W can be kept constant. The polishing liquid supply nozzle 102 supplies a polishing liquid Q onto the polishing surface 101a of the polishing pad 101 in advance, so that the polishing liquid Q is held on the polishing pad 101. Thus, the semiconductor wafer W is polished in the presence of the polishing liquid Q between the (lower) surface, to be polished, of the semiconductor wafer W and the polishing pad 101.

With the top ring 1 serving as the substrate holding apparatus according to the present embodiment, since the contact area between the edge membrane 7 and the outer circumferential edge of the semiconductor wafer W is kept constant, a pressing force applied to the outer circumferential edge of the semiconductor wafer W is prevented from being changed. Therefore, the entire surface including the outer circumferential edge of the semiconductor wafer W can be pressed against the polishing surface 101a under a uniform pressing force. As a result, a polishing rate at the outer circumferential edge of the semiconductor wafer W is prevented from being lowered. Further, a polishing rate at a region positioned radially inwardly of the outer circumferential edge of the semiconductor wafer W is prevented from being increased. Specifically, in the case where the semiconductor wafer has a diameter of 200 mm, the polishing rate at a region apart from the outer circumferential edge of the semiconductor wafer W by a distance of about 20 mm is prevented from being increased. In the case where the semiconductor wafer has a diameter of 300 mm, the polishing rate at a region apart from the outer circumferential edge of the semiconductor wafer W by a distance of about 25 mm is prevented from being increased.

The circumferentially extending slit 18 formed in the contact portion 8 of the edge membrane 7 is effective to increase the stretchability of the circumferential wall 9 (the outer circumferential wall 9a and the inner circumferential wall 9b) in the downward direction. Therefore, even when a pressure of the pressurized fluid supplied to the pressure chamber 22 is small, the contact area between the edge membrane 7 and the semiconductor wafer W can be kept constant. Thus, it is possible to press the semiconductor wafer W under a smaller pressing force.

The local areas of the semiconductor wafer W that are positioned beneath the pressure chambers 22, 23, 24 and 25 are pressed against the polishing surface 101a under the pressures of the pressurized fluids supplied to the pressure chambers 22, 23, 24 and 25. Therefore, the pressures of the pressurized fluids supplied to the pressure chambers 22, 23, 24 and 25 are controlled independently of each other, so that the entire surface of the semiconductor wafer W can be pressed against the polishing surface under a uniform pressing force. As a result, a uniform polishing rate can be obtained over the entire surface of the semiconductor wafer W. In the same manner, the regulator R2 regulates the pressure of the pressurized fluid supplied to the pressure chamber 21 so as to change the pressing force applied to the polishing pad 101 by the retainer ring 3. In this manner, during polishing, the pressing force applied to the polishing pad 101 by the retainer ring 3 and the pressing forces applied by the respective pressure chambers 22, 23, 24 and 25 to press the semiconductor wafer W against the polishing pad 101 are appropriately adjusted so as to control the polishing profile of the semiconductor wafer W. The semiconductor wafer W has an area to which the pressing force is applied by the pressurized fluid through the contact portion of the intermediate air bag 19, and an area to which the pressure of the pressurized fluid is directly applied. The pressing forces applied to these areas have the same pressure as each other.

As described above, the pressing force applied by the top ring air cylinder 111 to press the retainer ring 3 against the polishing pad 101 and the pressing forces applied by the pressurized fluids supplied to the pressure chambers 22, 23, 24 and 25 to press the semiconductor wafer W against the polishing pad 101 are appropriately adjusted to polish the semiconductor wafer W. When the polishing of the semiconductor wafer W is finished, the supply of the pressurized fluids into the pressure chambers 22, 23, 24 and 25 is stopped, and the pressures in the pressure chambers 22, 23, 24 and 25 are reduced to the atmospheric pressure. Thereafter, the pressure chamber 23 or the pressure chamber 24 is evacuated to produce a negative pressure therein, so that the semiconductor wafer W is attracted to the lower surface of the top ring 1 again. At this time, the atmospheric pressure or a negative pressure is produced in the pressure chamber 21. This is because if the pressure chamber 21 is maintained at a high pressure, then the semiconductor wafer W is locally pressed against the polishing surface 101a by the lower surface of the chucking plate 6.

After attraction of the semiconductor wafer W in a manner as described above, the top ring 1 as a whole is moved to the transfer position, and then a fluid (e.g., a pressurized fluid or a mixture of nitrogen and pure water) is ejected from the fluid passage 35 to the semiconductor wafer W so as to release the semiconductor wafer W from the top ring 1.

The polishing liquid Q used to polish the semiconductor wafer W tends to flow into the small gap G between the outer circumferential surface of the edge membrane 7 and the retainer ring 3. If the polishing liquid Q is firmly deposited in the gap G, then the holder ring 5, the chucking plate 6, and the edge membrane 7 are prevented from moving smoothly vertically with respect to the top ring body 2 and the retainer ring 3. In order to avoid such a drawback, a cleaning liquid such as pure water is supplied through the fluid passage 30 to the annular cleaning liquid passage 51. Accordingly, the pure water is supplied through a plurality of the communication holes 53 to a space above the gap G, thus cleaning the gap G to prevent the polishing liquid Q from being firmly deposited in the gap G. The pure water is preferably supplied after the polished semiconductor wafer W is released and until a next semiconductor wafer to be polished is attracted to the top ring 1.

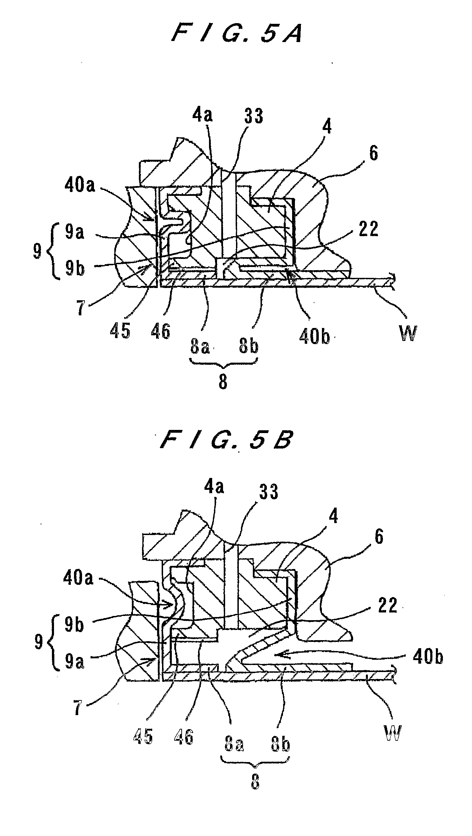

A substrate holding apparatus according to a second embodiment will be described below with reference to FIGS. 5A and 5B. FIGS. 5A and 5B are fragmentary cross-sectional views showing the substrate holding apparatus according to the second embodiment. Structural details of the substrate holding apparatus according to the second embodiment which will not be described below are identical to those of the substrate holding apparatus according to the first embodiment.

As shown in FIG. 5A, a stretchable and contractible portion 40a formed in the outer circumferential wall 9a is positioned near the upper end of the outer circumferential wall 9a. The edge ring 4 has an annular housing groove 4a for housing the stretchable and contractible portion 40a therein. The housing groove 4a is formed in the outer circumferential surface of the edge ring 4, and extends in the circumferential direction of the edge ring 4. As shown in FIG. 5B, the housing groove 4a has a width large enough to allow the stretchable and contractible portion 40a to be kept out of contact with the edge ring 4 even when the stretchable and contractible portion 40a is stretched downwardly. The edge ring 4 has a pressing member 45 which is brought into contact with an upper surface of the outer contact portion 8a (the contact portion 8) for pressing the outer contact portion 8a against the outer circumferential edge of the semiconductor wafer W. A plurality of radially extending grooves 46 are formed on a lower surface of the pressing member 45. The pressurized fluid supplied through the fluid passage 33 to the pressure chamber 22 is supplied through the grooves 46 to the upper surface of the outer contact portion 8a constituting the contact portion 8. In the present embodiment, the pressing member 45 is integrally formed with the edge ring 4. However, the pressing member 45 may be separate from the edge ring 4.

Operation of the substrate holding apparatus having the above structure according to the present embodiment will be described below. Operational details of the substrate holding apparatus according to the second embodiment which will not be described below are identical to those of the substrate holding apparatus according to the first embodiment.

The semiconductor wafer W is placed on the polishing surface 101a by the top ring 1, and then a pressurized fluid is supplied to the pressure chamber 21 so as to move the chucking plate 6 and the edge ring 4 downwardly. At this time, the lower surface of the pressing member 45 is brought into contact with the upper surface of the outer contact portion 8a, so that the pressing member 45 presses the outer contact portion 8a against the semiconductor wafer W under a predetermined pressure. The edge membrane 7 and the semiconductor wafer W are thus held in sufficiently intimate contact with each other. In this state, a pressurized fluid is supplied to the pressure chambers 22, 23, 24 and 25.

The pressurizing fluid supplied through the fluid passage 33 to the pressure chamber 22 is quickly supplied through the grooves 46 to the upper surface of the outer contact portion 8a. Therefore, at the same time that the pressurized fluid is supplied to the pressure chamber 22, the pressurized fluid presses the outer contact portion 8a against the semiconductor wafer W. As the pressurized fluid is supplied to the pressure chambers 22, 23, 24 and 25, the chucking plate 6 is moved upwardly, and the stretchable and contractible portion 40a of the outer circumferential wall 9a and the stretchable and contractible portion 40b of the inner circumferential wall 9b are stretched. At this time, the stretchable and contractible portion 40a is deformed within the housing groove 4a formed in the edge ring 4. Therefore, the stretchable and contractible portion 40a is prevented from being brought into contact with the edge ring 4 and hence an excellent stretchability thereof can be secured. In this manner, the semiconductor wafer W is polished while being pressed against the polishing surface 101a by the pressure chambers 22, 23, 24 and 25.

According to the substrate holding apparatus having the above structure, the pressing member 45 can bring the edge membrane 7 into intimate contact with the semiconductor wafer W. Therefore, it is possible to prevent the pressurized fluid supplied to the pressure chamber 22 from leaking. Further, the pressurized fluid can quickly be supplied through the grooves 46 to the upper surface of the outer contact portion 8a. Therefore, the pressurized fluid can start pressing the outer contact portion 8a against the semiconductor wafer W while the edge membrane 7 is being pressed by the pressing member 45. Furthermore, the stretchable and contractible portion 40a is positioned near the upper end of the outer circumferential wall 9a. Therefore, the stretchability of the outer circumferential wall 9a can be increased, and the outer circumferential wall 9a is prevented from being twisted in the circumferential direction, thus allowing the edge membrane 7 to behave in the same manner at all times.

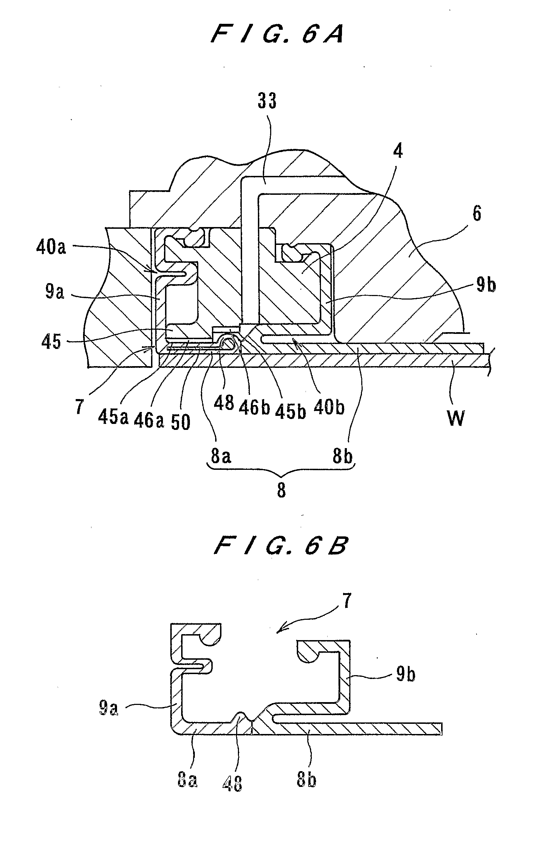

An edge membrane 7 according to a third embodiment will be described below with reference to FIGS. 6A and 6B. FIG. 6A is a fragmentary cross-sectional view showing a substrate holding apparatus according to the third embodiment, and FIG. 6B is a fragmentary cross-sectional view showing another structure of an edge membrane in the third embodiment.

Structural Structural and and operational details of the substrate holding apparatus according to the third embodiment which will not be described below are identical to those of the substrate holding apparatus according to the second embodiment.

As shown in FIG. 6A, the outer contact portion 8a constituting the contact portion 8, to be pressed by the pressing member 45, has a thick portion 48 on the upper surface thereof. The thick portion 48 extends in the circumferential direction of the outer contact portion 8a, and has a substantially arcuate cross section. A reinforcement member 50 for reinforcing a strength of the outer contact portion 8a is embedded in the outer contact portion 8a. The pressing member 45 has a step on the lower surface thereof to form a first pressing surface 45a and a second pressing surface 45b positioned upwardly of the first pressing surface 45a. The first pressing surface 45a is brought into contact with the outer contact portion 8a, and the second pressing surface 45b is brought into contact with the thick portion 48. The first pressing surface 45a and the second pressing surface 45b have a plurality of radially extending grooves 46a, 46b formed therein, respectively. The grooves 46a, 46b allow the pressurized fluid to start pressing the outer contact portion 8a against the semiconductor wafer W while the edge membrane 7 is being pressed by the pressing member 45, as with the second embodiment.

As described above, according to the present embodiment, the outer contact portion 8a, to be pressed by the pressing member 45, has the thick portion 48, and the reinforcement member 50 is embedded in the outer contact portion 8a. With this structure, it is possible to enhance the mechanical strength of the outer contact portion 8a. Thus, when the outer contact portion 8a is pressed against the semiconductor wafer W by the pressing member 45, the outer contact portion 8a is prevented from being twisted in the circumferential direction. As a result, the edge membrane 7 and the semiconductor wafer W can be kept in intimate contact with each other, thus preventing the pressurized fluid from leaking.

Further, since the thick portion 48 has a substantially arcuate cross section, the polishing liquid which has entered the pressure chamber 22 is less liable to firmly deposited at the thick portion 48. Furthermore, the lower surface, i.e. the second pressing surface 45b, of the pressing member 45 and the thick portion 48 are not held in intimate contact with each other, thus enabling the pressing member 45 to be easily brought out of contact with the thick portion 48. Only one of the thick portion 48 or the reinforcement member 50 may be used to reinforce the contact portion 8. As shown in FIG. 6B, the thick portion 48 may have a triangular cross section.

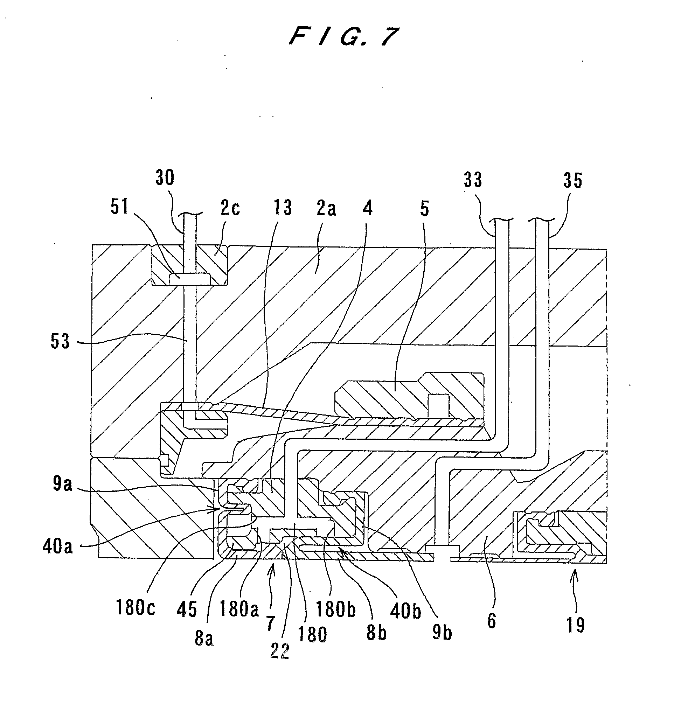

A substrate holding apparatus according to a fourth embodiment will be described below with reference to FIG. 7. FIG. 7 is a fragmentary cross-sectional view showing the substrate holding apparatus according to the fourth embodiment. Structural and operational details of the substrate holding apparatus according to the fourth embodiment which will not be described below are identical to those of the substrate holding apparatus according to the third embodiment. The substrate holding apparatus according to the fourth embodiment is different from the substrate holding apparatus according to the third embodiment in that a fluid supply port for supplying a pressurized fluid to the upper surface of the contact portion is provided in the edge ring, instead of providing the grooves in the lower surface of the pressing member.

As shown in FIG. 7, the edge ring 4 has a through hole 180 formed therein which communicates with the fluid passage 33. The through hole 180 has three open mouths, i.e., a first open mouth 180a serving as a fluid supply port which opens toward the outer contact portion 8a (contact portion 8), a second open mouth 180b which opens toward the stretchable and contractible portion 40b of the inner circumferential wall 9b, and a third open mouth 180c which opens at the outer circumferential surface of the edge ring 4. A pressurized fluid introduced into the through hole 180 through the fluid passage 33 is divided into three flows of the fluid in the edge ring 4. Specifically, the pressurized fluid forming a first flow is supplied from the first open mouth 180a to the upper surface of the outer contact portion 8a, the pressurized fluid forming a second flow is supplied from the second open mouth 180b to the stretchable and contractible portion 40b of the inner circumferential wall 9b, and the pressurized fluid forming a third flow is supplied from the third open mouth 180c to a backside surface of the outer circumferential wall 9a.

With this structure, while the outer contact portion 8a is being pressed by the pressing member 45, the pressurized fluid is supplied to the upper surface of the outer contact portion 8a. Therefore, as with the third embodiment described above, while the edge membrane 7 is being pressed by the pressing member 45, the pressurized fluid can start pressing the outer contact portion 8a (contact portion 8).

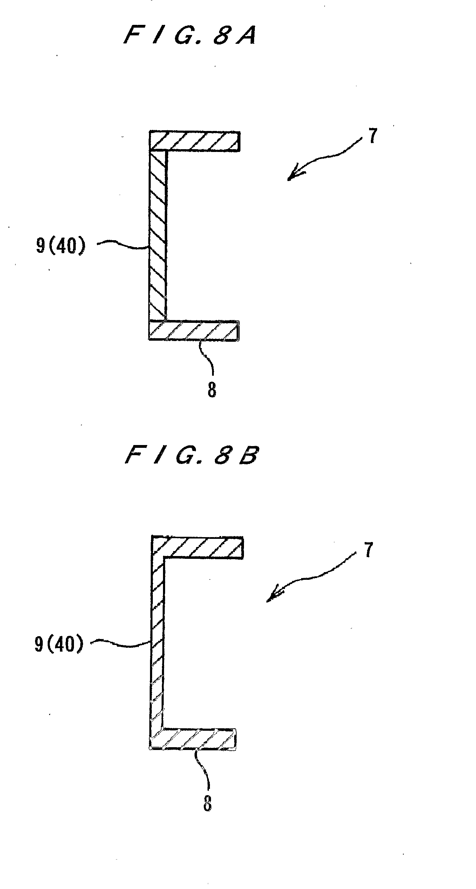

An edge membrane according to a fifth embodiment will be described below with reference to FIGS. 8A and 8B. FIG. 8A is a cross-sectional view showing the edge membrane according to the fifth embodiment and FIG. 8B is a cross-sectional view showing another structure of an edge membrane in the fifth embodiment.

With the edge membrane according to the first embodiment, the stretchable and contractible portion is provided by folding a portion of the circumferential wall along the circumferential direction. Alternatively, as shown in FIG. 8A, the circumferential wall 9 may be made of a material which is softer than the contact portion 8 so as to provide a stretchable and contractible portion 40. Alternatively, as shown in FIG. 8B, the circumferential wall 9 may be thinner than the contact portion 8 so as to provide a stretchable and contractible portion 40. According to these structures, as with the stretchable and contractible portions according to the above embodiments, the circumferential wall 9 can be stretched and contracted vertically, i.e., perpendicularly to the semiconductor wafer.

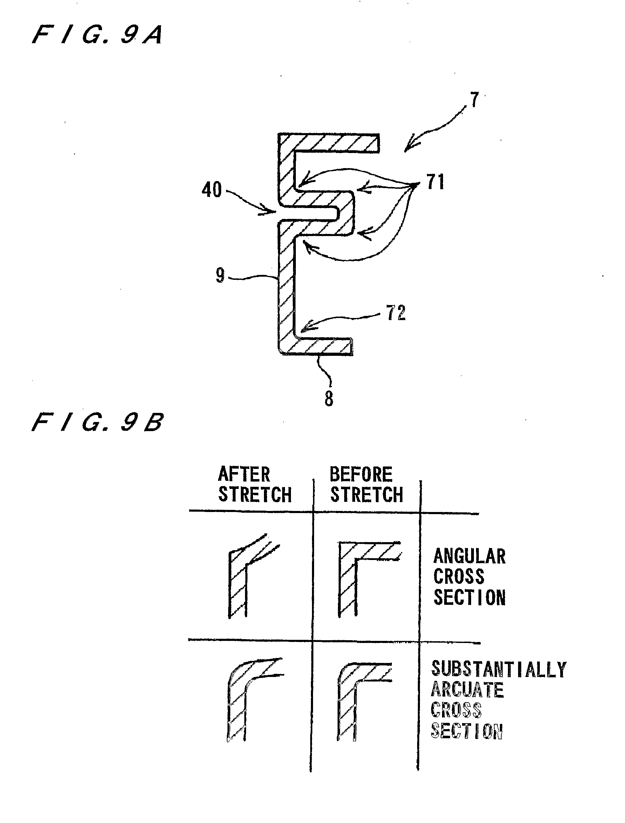

An edge membrane according to a sixth embodiment will be described below with reference to FIGS. 9A and 9B. FIG. 9A is a cross-sectional view showing the edge membrane according to the sixth embodiment, and FIG. 9B. is a reference view illustrating a stretchability of the edge membrane according to the sixth embodiment. The edge membrane according to the present embodiment has a basic structure which is identical to that of the edge membrane according to the second embodiment.

As shown in FIG. 9A, folded portions 71 of a stretchable and contractible portion 40 and a joint portion 72 between the circumferential wall 9 and the contact portion 8 have a substantially arcuate cross section, respectively. As shown in FIG. 9B, generally, if a joint portion between members has an angular cross section, then such an angular cross section is kept in shape even after these members are vertically stretched, thus causing the stretchability of the members to be restricted. On the other hand, if a joint portion between members has a substantially arcuate cross section, then such a joint portion can be deformed flexibly, thus providing the members with an excellent stretchability. With the above structure, therefore, the circumferential wall 9 including the stretchable and contractible portion 40 can be stretched smoothly.

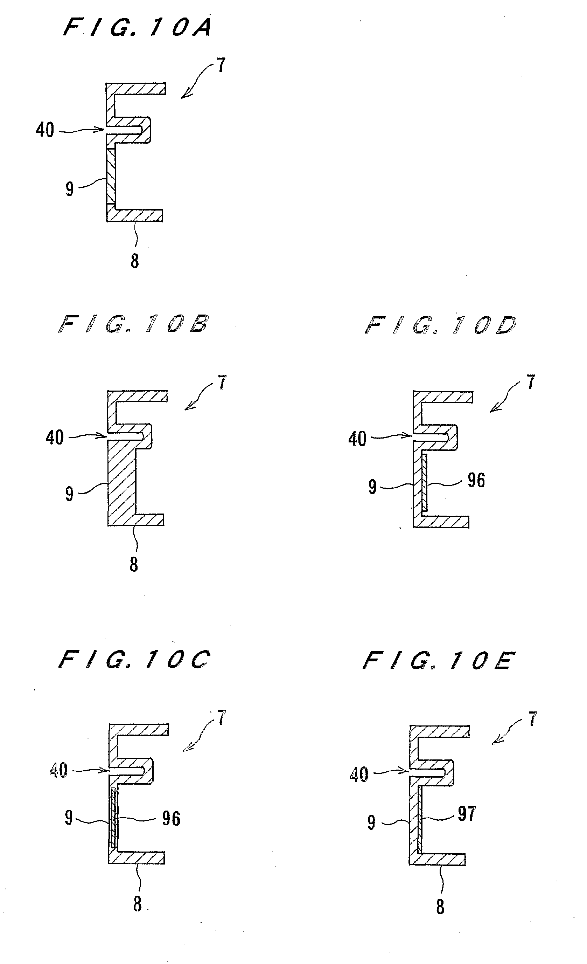

An edge membrane according to a seventh embodiment will be described below with reference to FIGS. 10A through 10E. FIG. 10A is a cross-sectional view showing the edge membrane according to the seventh embodiment, and FIGS. 10B through 10E are cross-sectional views each showing another structure of an edge membrane in the seventh embodiment. The edge membrane according to the present embodiment has a basic structure which is identical to that of the edge membrane according to the second embodiment.

Generally, when a semiconductor wafer is being polished, frictional force is produced between the semiconductor wafer held by the top ring and the polishing surface. Accordingly, the edge membrane may be twisted in the circumferential direction thereof, and hence an intimate contact between the edge membrane and the semiconductor wafer tends to be impaired. Therefore, in an edge membrane 7 shown in FIGS. 10A through 10E, in order to prevent the edge membrane from being twisted, a portion of the circumferential wall 9 positioned below the stretchable and contractible portion 40 has an enhanced mechanical strength.

Specifically, FIG. 10A shows an edge membrane 7 in which a portion of the circumferential wall 9 positioned below the stretchable and contractible portion 40 is made of a material harder than the contact portion 8. FIG. 10B shows an edge membrane 7 in which a portion of the circumferential wall 9 positioned below the stretchable and contractible portion 40 is thicker than the contact portion 8. FIG. 10C shows an edge membrane 7 in which a hard member 96 harder than the edge membrane 7 is embedded in a portion of the circumferential wall 9 positioned below the stretchable and contractible portion 40. FIG. 10D shows an edge membrane 7 in which a hard member 96 harder than the edge membrane 7 is fixed to a portion of the circumferential wall 9 positioned below the stretchable and contractible portion 40. FIG. 10E shows an edge membrane 7 in which a portion of the circumferential wall 9 positioned below the stretchable and contractible portion 40 is coated with a hard material 97 harder than the edge membrane 7. The hard member 96 preferably comprises a metal such as stainless steel having an excellent rust-resistant capability or a resin. The edge membranes 7 having the above structures are prevented from being twisted in the circumferential direction thereof when the semiconductor wafer is being polished, thus enabling the edge membrane 7 and the semiconductor wafer W to be kept in intimate contact with each other.

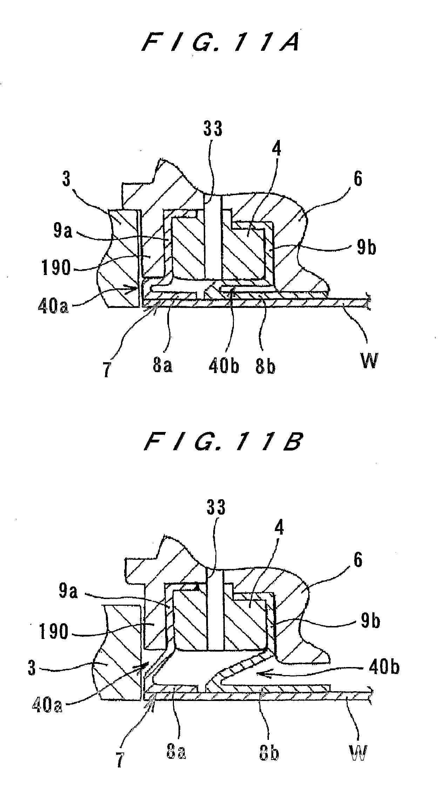

A substrate holding apparatus according to an eighth embodiment will be described below with reference to FIGS. 11A and 11B. FIGS. 11A and 11B are fragmentary cross-sectional views showing the substrate holding apparatus according to the eighth embodiment. Structural and operational details of the substrate holding apparatus according to the eighth embodiment which will not be described below are identical to those of the substrate holding apparatus according to the first embodiment.

As shown in FIG. 11A, the outer circumferential wall 9a is folded radially inwardly along the circumferential direction thereof at a position near the outer contact portion 8a, thus providing a stretchable and contractible portion 40a. The stretchable and contractible portion 40a is disposed below the edge ring 4. A protection member 190 is disposed radially outwardly of the outer circumferential wall 9a (circumferential wall 9). The protection member 190 serves to prevent the edge membrane 7 and the retainer ring 3 from being brought into contact with each other. The protection member 190 is disposed on the outer circumferential edge of the chucking plate 6 and is integrally formed with the chucking plate 6. Alternatively, the protection member 190 may be provided as a member separate from the chucking plate 6. With this structure, the edge membrane 7 and the retainer ring 3 are prevented from being brought into contact with each other, thus allowing the chucking plate 6 to move smoothly vertically.

A substrate holding apparatus according to a ninth embodiment will be described below. Structural and operational details of the substrate holding apparatus according to the ninth embodiment which will not be described below are identical to those of the substrate holding apparatus according to the first embodiment.

The outer contact portion 8a and the inner contact portion 8b constituting the contact portion 8 have a plurality of fine convexities and concavities (not shown) on upper surfaces thereof. Such convexities and concavities are preferably formed by a graining process, for example. The graining process is a process for forming regular or irregular convexities and concavities on a surface of a workpiece so as to roughen the surface. With this structure having such convexities and concavities on the upper surfaces of the outer contact portion 8a and the inner contact portion 8b, an adhesiveness of the inner contact portion 8b to the chucking plate 6 can be weakened. Therefore, when the chucking plate 6 is moved upwardly, the inner contact portion 8b of the edge membrane 7 is prevented from being moved upwardly together with the chucking plate 6. Further, in the case where the pressing member 45 is brought into contact with the outer contact portion 8a as described in the second embodiment, the pressing member 45 can be easily brought out of contact with the outer contact portion 8a. In the present embodiment, the lower surfaces of the outer contact portion 8a and the inner contact portion 8b of the contact portion 8 also have a plurality of fine convexities and concavities, so that the semiconductor wafer can be easily released from the edge membrane 7 after the substrate is polished.

In the above embodiments, the fluid passages 32, 33, 34, 35 and 36 are provided as separate passages. These fluid passages may be combined with each other, or the pressure chambers may be communicated with each other in accordance with the magnitude of the pressing force to be applied to the semiconductor wafer W and the position to which the pressing force is applied. The above embodiments may appropriately be combined with each other.

In the embodiments described above, the polishing surface is formed by the polishing pad. However, the polishing surface is not limited to such a structure. For example, the polishing surface may be formed by a fixed abrasive. The fixed abrasive is formed into a flat plate comprising abrasive particles fixed by a binder. With the fixed abrasive, a polishing process is performed by abrasive particles that are self-generated from the fixed abrasive. The fixed abrasive comprises abrasive particles, a binder, and pores. For example, cerium dioxide (CeO₂) having an average particle diameter of 0.5 µm or less is used as an abrasive particle, and epoxy resin is used as a binder. Such a fixed abrasive forms a harder polishing surface. The fixed abrasive includes a fixed abrasive pad having a two-layer structure formed by a thin layer of a fixed abrasive and an elastic polishing pad attached to a lower surface of the thin layer of the fixed abrasive. IC-1000 described above may be used for another hard polishing surface.

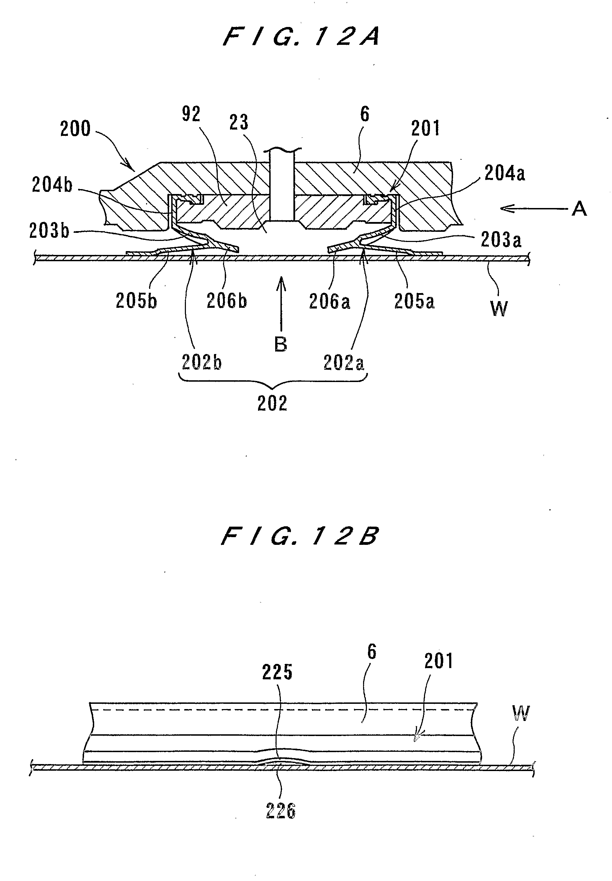

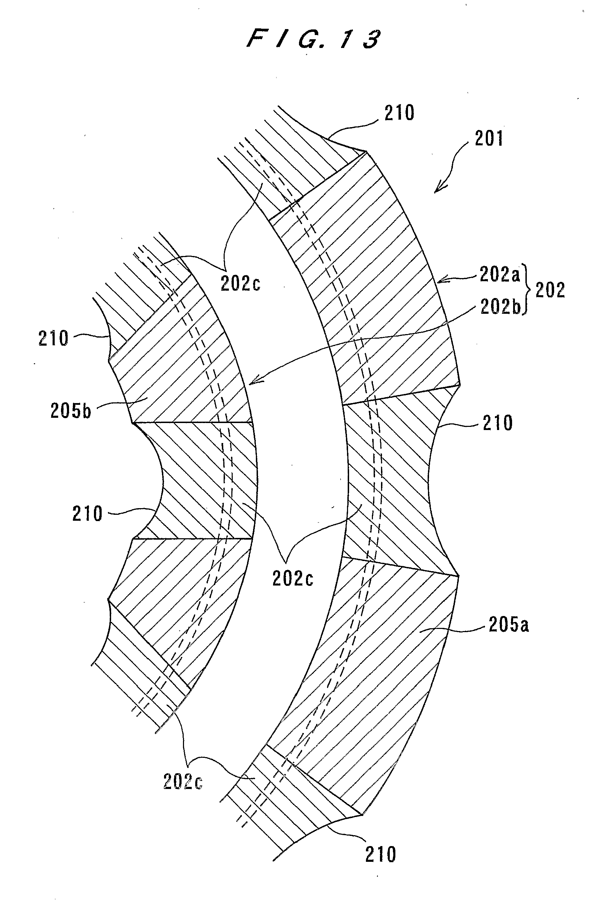

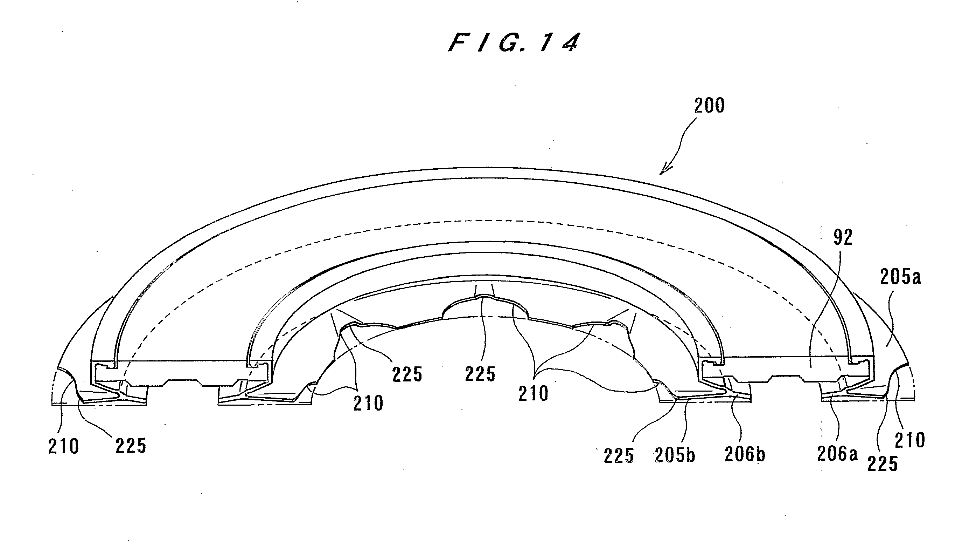

A substrate holding apparatus according to a tenth embodiment will be described below with reference to FIGS. 12A through 14. FIG. 12A is a cross-sectional view showing a part of the substrate holding apparatus according to the tenth embodiment, FIG. 12B is a view showing a part of the substrate holding apparatus as viewed in the direction indicated by the arrow A in FIG. 12A. FIG. 13 is a view showing a part of an intermediate membrane as viewed in the direction indicated by the arrow B in FIG. 12A. FIG. 14 is a perspective view showing an intermediate air bag incorporated in the substrate holding apparatus according to the tenth embodiment. Structural and operational details of the substrate holding apparatus according to the tenth embodiment which will not be described below are identical to those of the substrate holding apparatus according to the first embodiment.

An intermediate air bag 200 comprises an intermediate membrane 201 having an intermediate contact portion 202 which is brought into contact with the semiconductor wafer W. The intermediate membrane 201 serves as an elastic member and corresponds to the elastic membrane 91 in the first embodiment. The intermediate contact portion 202 has an outer intermediate contact portion 202a and an inner intermediate contact portion 202b. The outer intermediate contact portion 202a is disposed radially outwardly of the inner intermediate contact portion 202b. The outer intermediate contact portion 202a and the inner intermediate contact portion 202b have noses 205a, 205b extending outwardly from the pressure chamber 23 and base portions 206a, 206b disposed in the pressure chamber 23, respectively. Hereinafter, the outer intermediate contact portion 202a and the inner intermediate contact portion 202b may be collectively referred to as the intermediate contact portion 202. The noses 205a, 205b correspond to the flanges 91a in the first embodiment.

The intermediate membrane 201 has extending portions 203a, 203b connected to the noses 205a, 205b and extending in substantially parallel, to the intermediate contact portion 202. The intermediate membrane 201 also has connecting portions 204a, 204b extending upwardly from tip ends of the extending portions 203a, 203b and connected to the chucking plate 6 by the air bag holder 92. The pressure chamber 23 is defined by the intermediate membrane 201, the air bag holder 92, and the semiconductor wafer W.

As shown in FIGS. 13 and 14, the noses 205a, 205b have a plurality of arcuate notches 210, each serving as a removal promoting portion, which are formed in circumferential edges of the noses 205a, 205b at circumferentially equal intervals. As shown in FIG. 13, the notches 210 are formed in respective regions 202c of the intermediate contact portion 202. The regions 202c are arranged along the circumferential direction of the intermediate contact portion 202 at circumferentially equal intervals. Each of the regions 202c is made of a material having a lower adhesiveness to the semiconductor wafer W than that of the other regions of the intermediate contact portion 202. The surfaces, to be brought into contact with the semiconductor wafer W, of the regions 202c are grained to form fine convexities and concavities thereon by satin finish process or blasting process. The entire lower surface of the intermediate contact portion 202 may be grained. The graining process is a process for forming fine convexities and concavities on a surface of a workpiece.

The noses 205a, 205b have upwardly concave recesses 225, each serving as a removal promoting portion, which are formed in the circumferential edges thereof. As shown in FIG. 12B, a gap 226 is formed between the recess 225 and the semiconductor wafer W. When a pressurized fluid is supplied to the pressure chambers 23, 24 and 25 (see FIG. 2), the recesses 225 are deformed to be brought into intimate contact with the upper surface of the semiconductor wafer W, thus making the pressure chamber 23 airtight. At this time, the gap 226 is not formed. When pressures in the pressure chambers 23, 24 and 25 are reduced to, e.g., the atmospheric pressure, the recesses 225 are brought out of contact with the upper surface of the semiconductor wafer W. The recesses 225 are preferably formed in such positions that the lower portion of the chucking plate 6 is brought into contact with the recesses 225 when the chucking plate 6 is moved downwardly. In such positions, the recesses 225 are pressed downwardly against the semiconductor wafer W by the chucking plate 6, thus allowing the interior of the pressure chamber 23 to be sealed. In the present embodiment, the recesses 225 are formed in the notches 210, respectively, as shown in FIG. 14. However, locations of the recesses 225 are not limited to the positions of the notches 210.

Operation for releasing the semiconductor wafer according to the top ring, i.e. the substrate holding apparatus, having the above structure will be described below with reference to FIG. 2. After the polishing process is finished, the supply of the pressurized fluid to the pressure chambers 22, 23, 24 and 25 is stopped, and the pressures in the pressure chambers 22, 23, 24 and 25 are reduced to the atmospheric pressure. Then, the pressurized fluid is supplied to the pressure chamber 21 to move the chucking plate 6 downwardly, so that the contact portion 8 (see FIG. 4) and the intermediate contact portion 202 (see FIG. 12A) are brought into uniformly intimate contact with the upper surface of the semiconductor wafer W. In this state, a negative pressure is produced in the pressure chamber 23 or the pressure chamber 24 so as to attract the semiconductor wafer W under vacuum to the lower end of the top ring 1.

Thereafter, the top ring 1 is moved horizontally to an overhanging position where the top ring 1 overhangs the polishing table 100 (see FIG. 1), and then a negative pressure is produced in the pressure chamber 21 so as to move the chucking plate 6 upwardly. A negative pressure may be produced in the pressure chamber 21 when the top ring 1 is being moved to the overhanging position. Thereafter, the top ring 1 is moved upwardly to a position above a pusher, i.e. substrate lifting and lowering device which is not shown, that is disposed in the transfer position. Then, the attraction of the semiconductor wafer W under vacuum by the pressure chamber 23 or the pressure chamber 24 is stopped.

Next, a fluid (e.g., a pressurized fluid or a mixture of nitrogen and pure water) is ejected from the fluid passage 35 or the fluid passage 34 to the semiconductor wafer W. Specifically, in the case where the semiconductor wafer W has a diameter of 300 mm, the fluid is ejected from the fluid passage 35. In the case where the semiconductor wafer W has a diameter of 200 mm, the fluid is ejected from the fluid passage 34. When the fluid is ejected to the semiconductor wafer W, the notches 210 and the recesses 225 of the intermediate contact portion 202 starts being removed from the semiconductor wafer W, and hence an ambient gas flows into the pressure chamber 23. Therefore, a sealed state of the pressure chamber 23 produced by the intermediate contact portion 202 is broken, thus allowing the semiconductor wafer W to be released from the intermediate air bag 200 smoothly and quickly. The notches 210 formed in the intermediate contact portion 202 are effective to allow the intermediate contact portion 202, particularly the noses 205a, 205b, to be easily brought out of contact with the semiconductor wafer W. Therefore, it is possible to release the semiconductor wafer W from the intermediate air bag 200 quickly. In the present embodiment, the intermediate contact portion 202 has the regions 202c whose wide in the radial direction are smaller than that of other regions, thereby providing the notches 210.

In this embodiment, as described above, the intermediate contact portion 202 is partly made of a material having a low adhesiveness to the semiconductor wafer W, and the intermediate contact portion 202 is partly grained to form the fine convexities and concavities on the lower surface thereof. With this structure, the semiconductor wafer W can be released from the intermediate air bag 200 smoothly. It is preferable to supply a fluid such as pure water between the semiconductor wafer W and the intermediate contact portion 202 at the same time that a fluid is ejected from the fluid passage 35 or the fluid passage 34. With this structure, the semiconductor wafer W can be released from the intermediate air bag 200 more smoothly.

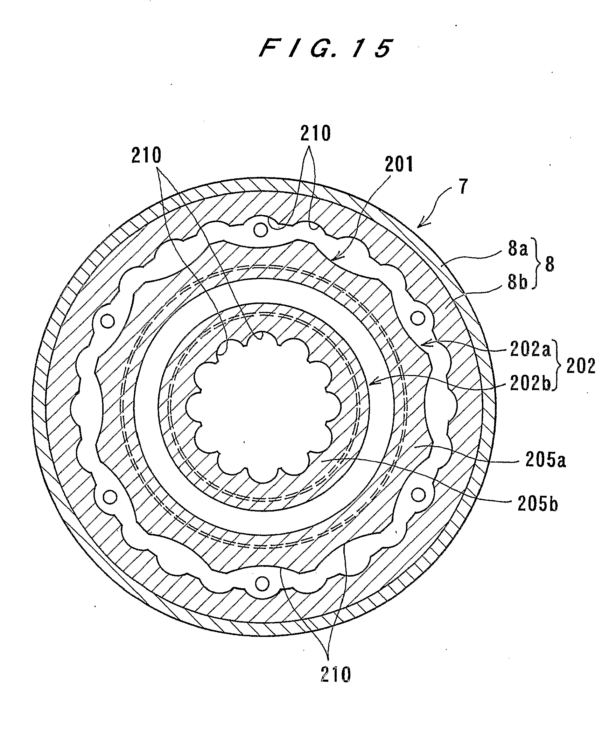

A substrate holding apparatus according to an eleventh embodiment will be described below with reference to FIG. 15. FIG. 15 is a rear view showing an elastic member of the substrate holding apparatus according to the eleventh embodiment.

Structural and operational details of the substrate holding apparatus according to the eleventh embodiment which will not be described below are identical to those of the substrate holding apparatus according to the first and tenth embodiments.

As shown in FIG. 15, an elastic member comprises an edge membrane 7 disposed in an outermost circumferential region, and an intermediate membrane 201 disposed radially inwardly of the edge membrane 7. An inner contact portion 8b of the edge membrane 7 has notches 210 formed in an inner circumferential edge thereof. A nose 205a of an outer intermediate contact portion 202a and a nose 205b of an inner intermediate contact portion 202b have notches 210 formed in circumferential edges thereof, respectively. With this structure, when a fluid is supplied from the fluid passage 35 or the fluid passage 34 (see FIG. 2), the edge membrane 7 and the intermediate membrane 201 can quickly be removed from the semiconductor wafer W. As described above, in the case where the semiconductor wafer W has a diameter of 300 mm, the fluid is ejected from the fluid passage 35, and in the case where the semiconductor wafer W has a diameter of 200 mm, the fluid is ejected from the fluid passage 34. At the same time that the fluid is ejected from the fluid passage 35 or the fluid passage 34, a fluid such as pure water is preferably supplied between the semiconductor wafer W and the contact portion 8, and between the semiconductor wafer W and the intermediate contact portion 202.

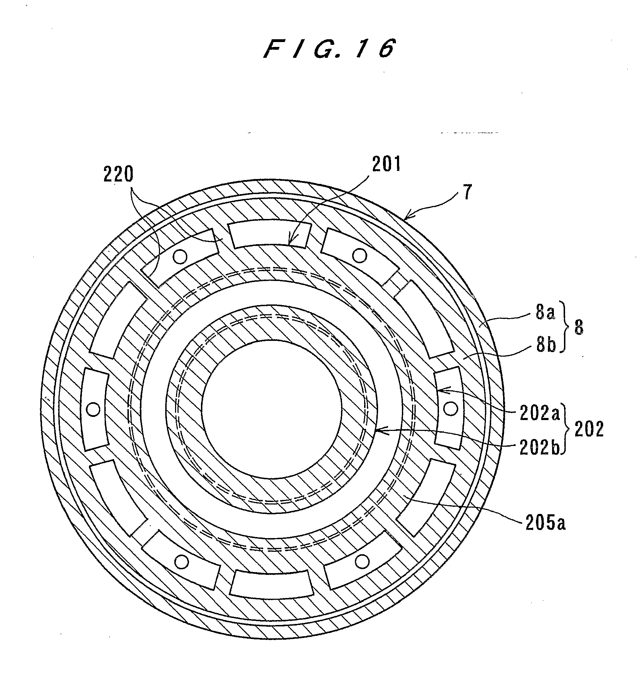

A substrate holding apparatus according to a twelfth embodiment will be described below with reference to FIGS. 16 through 19. FIG. 16 is a rear view showing a first example of an elastic member incorporated in the substrate holding apparatus according to the twelfth embodiment.

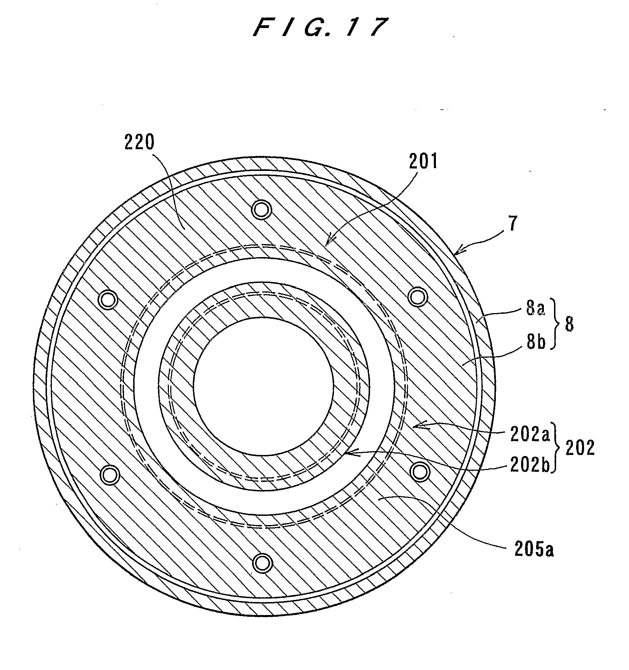

FIG. 17 is a rear view showing a second example of an elastic member incorporated in the substrate holding apparatus according to the twelfth embodiment.

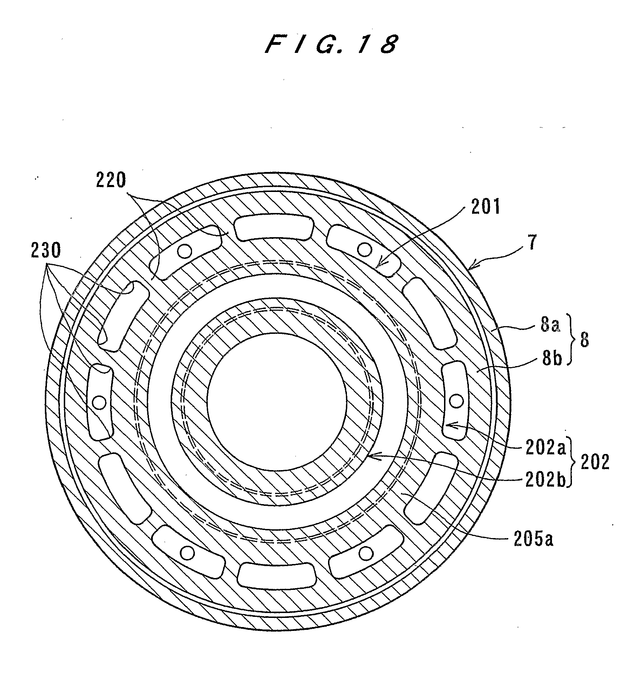

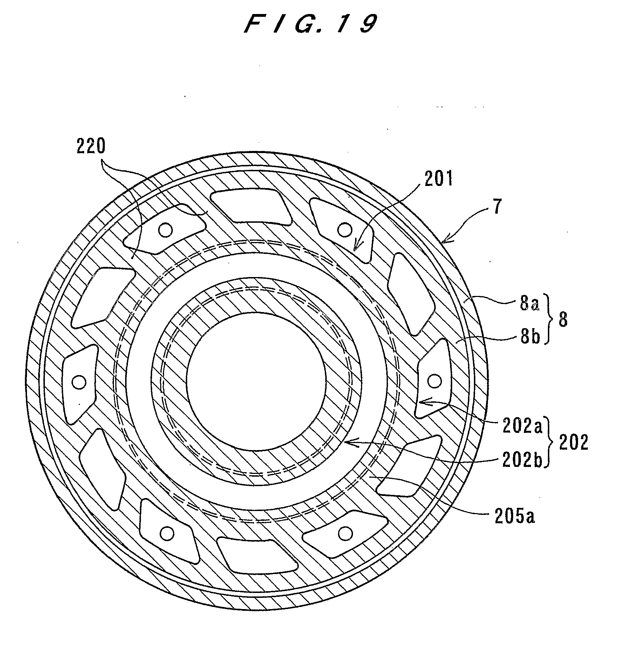

FIG. 18 is a rear view of a third example of an elastic member incorporated in the substrate holding apparatus according to the twelfth embodiment. FIG. 19 is a rear view showing a fourth example of an elastic member incorporated in the substrate holding apparatus according to the twelfth embodiment. Structural and operational details of the substrate holding apparatus according to the twelfth embodiment will not be described below are identical to those of the substrate holding apparatus according to the first and tenth embodiments.

As shown in FIGS. 16 through 19, an elastic member comprises an edge membrane 7 disposed in an outermost circumferential region, and an intermediate membrane 201 disposed radially inwardly of the edge membrane 7. In a first example of the present embodiment shown in FIG. 16, a contact portion 8 of the edge membrane 7 and an intermediate contact portion 202 of the intermediate membrane 201 are connected to each other by a plurality of interconnecting portions 220 each serving as a removal promoting portion. Specifically, an inner contact portion 8b of the contact portion 8 and a nose 205a of an outer intermediate contact portion 202a are interconnected by the interconnecting portions 220. The interconnecting portions 220 extend radially from a circumferential edge of the nose 205a and are disposed at equal intervals in the circumferential direction of the nose 205a.

In a second example of the present embodiment shown in FIG. 17, the inner contact portion 8b and the nose 205a of the outer intermediate contact portion 202a are integrally connected to each other by an annular interconnecting portion 220. With this structure, the inner contact portion 8b, the outer intermediate contact portion 202a, and the interconnecting portion 220 are integrally formed as a single annular member.

In a third example of the present embodiment shown in FIG. 18, the inner contact portion 8b and the nose 205a are connected to each other by a plurality of radial interconnecting portions 220. Joint portions between the interconnecting portions 220 and the inner contact portion 8b, and joint portions between the interconnecting portions 220 and the nose 205a have fillets 230, respectively, for preventing stress from concentrating on these joint portions.

In a fourth example of the present embodiment shown in FIG. 19, the inner contact portion 8b and the nose 205a are connected to each other by a plurality of interconnecting portions 220 which extend obliquely to the radial direction.

With the structures shown in FIGS. 16 through 19, stretch of the nose 205a is limited by the interconnecting portions 220. Accordingly, the nose 205a is prevented from being stretched as the semiconductor wafer W is moved downwardly when released. Therefore, when a fluid is ejected from the fluid passage 35 or the fluid passage 34, the semiconductor wafer W can quickly be released from the elastic member, i.e. the edge membrane 7 and the intermediate membrane 201. In the case where the semiconductor wafer W has a diameter of 300 mm, the fluid is ejected from the fluid passage 35, and in the case where the semiconductor wafer W has a diameter of 200 mm, the fluid is ejected from the fluid passage 34. A fluid such as pure water is preferably supplied between the semiconductor wafer W and the contact portion 8, and between the semiconductor wafer W and the intermediate contact portion 202. The reason why the inner contact portion 8b and the circumferential edge of the nose 205a are interconnected by the interconnecting portions 220 is that experiments show that the nose 205a of the outer intermediate contact portion 202a is most unlikely to be removed from the semiconductor wafer W.

Various embodiments have been described above. However, the present invention is not limited to the above embodiments. Various modifications may be made within the scope of the claims. As described above, since the stretchable and contractible portion is stretched downwardly so as to follow the upward movement of the vertically movable member, i.e. chucking plate, the contact portion which is held in contact with the substrate can be kept in shape. Therefore, the contact area between the elastic member and the substrate can be kept constant, and a uniform pressing force can be thus obtained over the entire surface of the substrate.

Even when the retainer ring is worn to cause a change in a distance between the vertically movable member and the substrate, since the stretchable and contractible portion is stretched so as to follow the change of the distance. Thus, the contact portion which is held in contact with the substrate can be kept in shape. Consequently, it is possible to press the substrate under a uniform pressure over the entire region from the center of the substrate to the outer circumferential edge thereof. Therefore, a uniform polishing rate, i.e., polishing profile, can be achieved over the entire surface of the substrate. Further, since the stretchable and contractible portion is contracted in accordance with wear on the retainer ring, the worn retainer ring can be used without being replaced.

Furthermore, when the fluid is ejected to the upper surface of the substrate, the removal promoting portion starts being removed from the substrate to allow the contact portion to be smoothly removed from the substrate. Therefore, the substrate can be transferred to a substrate lifting and lowering device such as a pusher without being damaged by a fluid pressure. The substrate can also well be released from the elastic member without being affected by the type of the substrate, particularly the type of the film that is formed on the backside surface (upper surface) of the substrate.

A substrate holding apparatus and a polishing apparatus according to a thirteenth embodiment will be described in detail below with reference to the drawings.

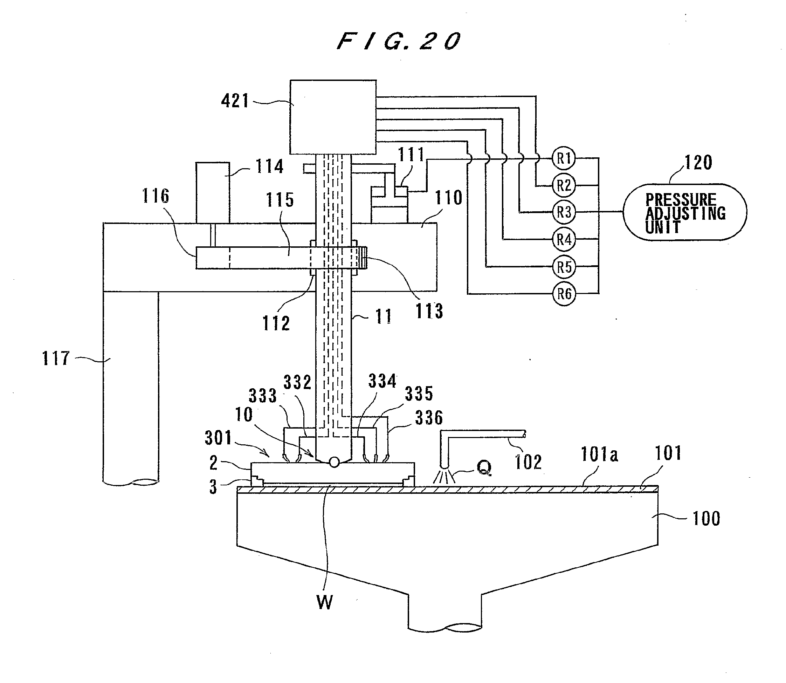

FIG. 20 is a cross-sectional view showing an entire structure of a polishing apparatus having a substrate holding apparatus according to the thirteenth embodiment. Structural and operational details of the substrate holding apparatus and the polishing apparatus according to the thirteenth embodiment which will not be described below are identical to those of the substrate holding apparatus and the polishing apparatus according to the first embodiment.

As shown in FIG. 20, fluid passages 332, 333, 334, 335 and 336 extend through the interior of the top ring drive shaft 11, and are connected to the pressure adjusting unit 120 through a rotary joint 421 disposed on an upper end of the top ring drive shaft 11.

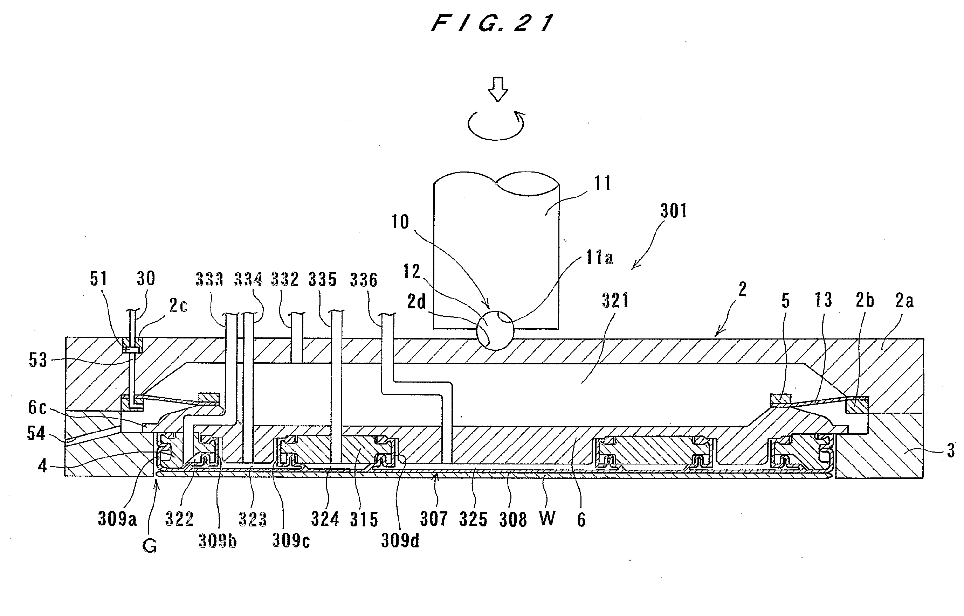

A top ring 301 serving as the substrate holding apparatus according to the present invention will be described below. FIG. 21 is a vertical cross-sectional view showing a top ring according to the thirteenth embodiment.

As shown in FIG. 21, the top ring body 2 and the retainer ring 3 integrally fixed to the top ring body 2 define a housing space therein. The annular holder ring 5 and the disk-shaped chucking plate 6 serving as a movable member is disposed in the housing space. The chucking plate 6 is movable in a vertical direction within the housing space formed in the top ring body 2. The vertical direction means a direction perpendicular to the polishing surface 101a. The top ring body 2, the chucking plate 6, the holder ring 5, and the pressurizing sheet 13 jointly define a pressure chamber 321 in the top ring body 2. As shown in FIG. 21, the pressure chamber 321 communicates with the fluid passage 332 comprising a tube, a connector, and the like. The pressure chamber 321 is connected to the pressure adjusting unit 120 via the regulator R2 provided on the fluid passage 332.

An elastic membrane 307, to be brought into contact with the semiconductor wafer W, is attached to a lower portion of the chucking plate 6. The elastic membrane 307 has a circular contact portion 308 which is brought into contact with the entire upper surface of the semiconductor wafer W. The elastic membrane 307 also has a plurality of annular circumferential walls extending upwardly from the contact portion 308 and connected to the chucking plate 6. Specifically, the circumferential walls comprise a first circumferential wall 309a, a second circumferential wall 309b, a third circumferential wall 309c, and a fourth circumferential wall 309d, which are collectively referred to as circumferential walls 309a through 309d. The elastic membrane 307 has an integral structure as a one-piece member.

The first circumferential wall 309a is disposed on an outer circumferential edge of the contact portion 308. The second circumferential wall 309b is disposed radially inwardly of the first circumferential wall 309a with a predetermined distance from the first circumferential wall 309a. The third circumferential wall 309c is disposed radially inwardly of the second circumferential wall 309b with a predetermined distance from the second circumferential wall 309b. The fourth circumferential wall 309d is disposed radially inwardly of the third circumferential wall 309c with a predetermined distance from the third circumferential wall 309c. The first circumferential wall 309a, the second circumferential wall 309b, the third circumferential wall 309c, and the fourth circumferential wall 309d are arranged concentrically with each other.

The first circumferential wall 309a and the second circumferential wall 309b have respective upper ends clamped between the chucking plate 6 and the annular edge ring 4. The third circumferential wall 309c and the fourth circumferential wall 309d have respective upper ends clamped between the chucking plate 6 and an annular holder 315. The edge ring 4 and the holder 315 are fastened to the chucking plate 6 by bolts (not shown), respectively, so that the elastic membrane 307 is detachably mounted on the chucking plate 6.

The elastic membrane 307 is made of a highly strong and durable rubber material such as ethylene propylene rubber (EPDM), polyurethane rubber, silicone rubber, as with the pressurizing sheet 13. The rubber material of the elastic membrane 307 should preferably have a hardness (duro) ranging from 20 to 60. The elastic membrane 307 may have a single circumferential wall, or may have a plurality of circumferential walls as with the present embodiment.

Four pressure chambers 322, 323, 324 and 325 are defined on a backside surface, i.e. an upper surface, of the elastic membrane 307. Specifically, the contact portion 308, the first circumferential wall 309a, the second circumferential wall 309b, and the edge ring 4 defines an annular space serving as the pressure chamber 322. The pressure chamber 322 communicates with the fluid passage 333 comprising a tube, a connector, and the like. The pressure chamber 322 is connected to the pressure adjusting unit 120 through the regulator R3 provided on the fluid passage 333.

The contact portion 308, the second circumferential wall 309b, the third circumferential wall 309c, and the chucking plate 6 defines an annular space serving as the pressure chamber 323. The pressure chamber 323 communicates with the fluid passage 334 comprising a tube, a connector, and the like. The pressure chamber 323 is connected to the pressure adjusting unit 120 through the regulator R4 provided on the fluid passage 334.

The contact portion 308, the third circumferential wall 309c, the fourth circumferential wall 309d, and the holder 315 defines an annular space serving as the pressure chamber 324. The pressure chamber 324 communicates with the fluid passage 335 comprising a tube, a connector, and the like. The pressure chamber 324 is connected to the pressure adjusting unit 120 through the regulator R5 provided on the fluid passage 335.

The contact portion 308, the fourth circumferential wall 309d, and the chucking plate 6 defines a circular space serving as the pressure chamber 325. The pressure chamber 325 communicates with the fluid passage 336 comprising a tube, a connector, and the like. The pressure chamber 325 is connected to the pressure adjusting unit 120 through the regulator R6 provide on the fluid passage 336. The fluid passages 332, 333, 334, 335 and 336 extend through the interior of the top ring drive shaft 11, and are connected to the regulators R2 through R6 through the rotary joint 421, respectively.

The pressure chamber 321 defined above the chucking plate 6 and the pressure chambers 322, 323, 324 and 325 are supplied with a pressurized fluid such as pressurized air, or atmospheric pressure or vacuum is produced in the pressure chambers 321, 322, 323, 324 and 325, through the fluid passages 332, 333, 334, 335 and 336 connected to the respective pressure chambers. Specifically, the regulators R2 through R6 provided respectively on the fluid passages 332, 333, 334, 335 and 336 can respectively regulate the pressures of the pressurized fluids supplied to the respective pressure chambers 321, 322, 323, 324 and 325. Thus, it is possible to independently control the pressures in the pressure chambers 321, 322, 323, 324 and 325, or independently produce atmospheric pressure or vacuum in the pressure chambers 321, 322, 323, 324 and 325.

The pressures in the respective pressure chambers 322, 323, 324 and 325 are independently controlled based on a film thickness measured by one or more film thickness measuring devices that are embedded in the polishing table 100 for measuring a thickness of a film on the polished surface of the semiconductor wafer W. The film thickness measuring device may comprise an optical-type film thickness measuring device which utilizes light interference or light reflection, or an eddy-current-type film thickness measuring device. A signal from the film thickness measuring device is analyzed based on radial positions of the semiconductor wafer W so as to control the internal pressures of the respective pressure chambers 322, 323, 324 and 325 which are concentrically arranged.

In this case, the pressurized fluid supplied to the pressure chambers 322, 323, 324 and 325, or atmospheric air supplied to the above pressure chambers when producing the atmospheric pressure therein may independently be controlled in temperature. With such a structure, it is possible to directly control the temperature of a workpiece such as a semiconductor wafer from the backside of the surface to be polished. Particularly, when the temperatures of the respective pressure chambers are independently controlled, the rate of chemical reaction can be controlled in the chemical polishing process of CMP.

The temperatures in the pressure chambers 322, 323, 324 and 325 are usually controlled based on a signal from the film thickness measuring device, in the same manner as the internal pressure control of the respective pressure chambers described above.

The retainer ring 3 has an air vent hole 54 formed therein. The communication holes 53 communicate with the air vent hole 54 and a small gap G formed between an outer circumferential surface of the elastic membrane 307 (the first circumferential wall 309a) and the inner circumferential surface of the retainer ring 3.

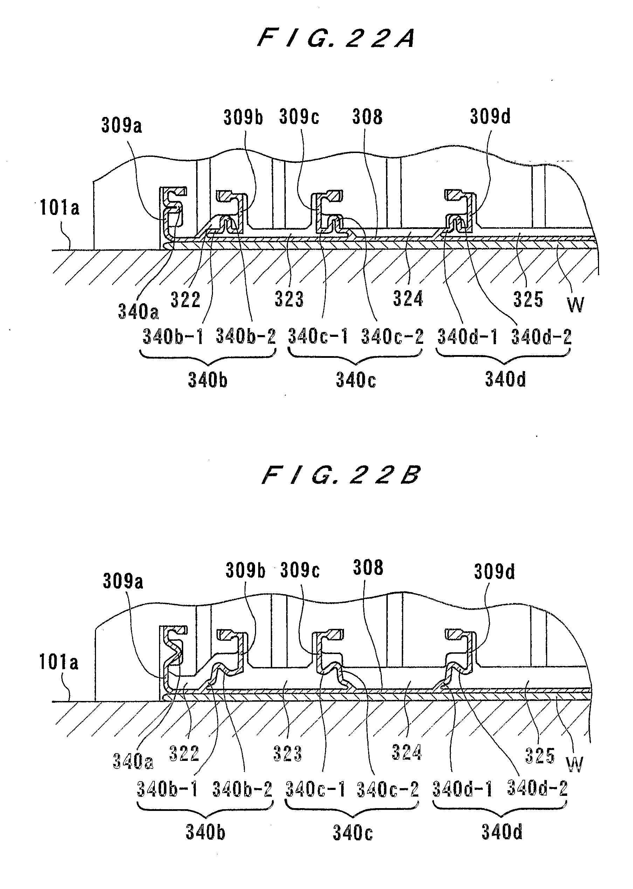

The elastic membrane 307 according to the present embodiment will be described in detail below with reference to FIGS. 22A and 22B. FIG. 22A is a view showing a part of the top ring according to the thirteenth embodiment of the present invention, and FIG. 22B is a view showing the state in which a fluid is supplied to the pressure chambers. In order to simplify the drawing, structural details other than the elastic membrane are schematically illustrated in FIGS. 22A and 22B.

As shown in FIG. 22A, the first circumferential wall 309a has a stretchable and contractible portion 340a which is stretchable and contractible vertically, i.e., perpendicularly to the polishing surface 101a. The stretchable and contractible portion 340a comprises a folded-back portion projecting radially inwardly. The stretchable and contractible portion 340a is positioned in a substantially central region of the first circumferential wall 309a where the stretchable and contractible portion 340a has no influence on the contact portion 308. The second circumferential wall 309b also has a stretchable and contractible portion 340b which is stretchable and contractible vertically. The stretchable and contractible portion 340b comprises a horizontal portion 340b-1 extending radially outwardly and positioned near the lower end of the second circumferential wall 309b, and a folded-back portion 340b-2 projecting upwardly from the horizontal portion 340b-1. The folded-back portion 340b-2 is stretchable and contractible in a horizontal direction, i.e. in parallel to the polishing surface 101a.

The third circumferential wall 309c has a stretchable and contractible portion 340c which is stretchable and contractible vertically. The stretchable and contractible portion 340c comprises a horizontal portion 340c-1 extending radially inwardly and positioned near the lower end of the third circumferential wall 309c, and a folded-back portion 340c-2 projecting upwardly from the horizontal portion 340c-1. The fourth circumferential wall 309d also has a stretchable and contractible portion 340d which is stretchable and contractible vertically. The stretchable and contractible portion 340d comprises a horizontal portion 340d-1 extending radially outwardly and positioned near the lower end of the fourth circumferential wall 309d, and a folded-back portion 340d-2 projecting upwardly from the horizontal portion 340d-1. The folded-back portion 340c-2 and the folded-back portion 340d-2 are stretchable and contractible in a horizontal direction, i.e. in parallel to the polishing surface 101a.

Since the circumferential walls 309a, 309b, 309c and 309d have the stretchable and contractible portions 340a, 340b, 340c and 340d, respectively, the circumferential walls 309a, 309b, 309c and 309d can be stretched and contracted while the contact portion 308 is kept in shape. Specifically, the circumferential walls 309a, 309b, 309c and 309d including the respective stretchable and contractible portions 340a, 340b, 340c and 340d can be stretched uniformly in the vertical direction. Therefore, as shown in FIG. 22B, when a pressurized fluid is supplied to the pressure chambers 322, 323, 324 and 325 so as to lift the chucking plate 6 (see FIG. 21), the stretchable and contractible portions 340a, 340b, 340c and 340d are stretched so as to follow the upward movement of the chucking plate 6. Therefore, a constant are between the elastic membrane 307 (the contact portion 308) and the semiconductor wafer W can be kept constant.

Next, operation of the top ring 301 having the above structure will be described in detail.

In the polishing apparatus having the above structure, when a semiconductor wafer W is to be transferred to the polishing apparatus, the top ring 301 as a whole is moved to a transfer position where the semiconductor wafer W is transferred. In the case where the semiconductor wafer W has a diameter of 200 mm, the pressure adjusting unit 120 communicates with the pressure chamber 323 through the fluid passage 334. On the other hand, in the case where the semiconductor wafer W has a diameter of 300 mm, the pressure adjusting unit 120 communicates with the pressure chamber 324 through the fluid passage 335.

The contact portion 308 constituting the pressure chamber 323 and the pressure chamber 324 has holes or recesses (not shown), respectively, through which the semiconductor W is directly attracted to and held by the lower end of the top ring 301.

With the semiconductor wafer W attracted to the top ring 301, the top ring 301 as a whole is moved to a position above the polishing table 100 having the polishing surface 101a. The outer circumferential edge of the semiconductor wafer W is held by the retainer ring 3, so that the semiconductor wafer W is not removed from the top ring 301, or the semiconductor wafer W is not slid.

Thereafter, the attraction of the semiconductor wafer W is released. About at the same time, the top ring air cylinder 111 connected to the top ring drive shaft 11 is actuated to press the retainer ring 3 fixed to the lower end of the top ring 301 against the polishing surface 101a of the polishing table 100 under a predetermined pressure. Then, the pressurized fluid is supplied to the pressure chamber 321 so as to move the chucking plate 6 downwardly, thereby bringing the contact portion 308 of the elastic membrane 307 into contact with the semiconductor wafer W. Thereafter, the pressurized fluids having respective pressures are supplied respectively to the pressure chambers 322, 323, 324 and 325, so that the chucking plate 6 is moved upwardly and simultaneously the semiconductor wafer W is pressed against the polishing surface 101a. At this time, the stretchable and contractible portions 340a, 340b, 340c and 340d provided in the elastic membrane 307 are stretched so as to follow the upward movement of the chucking plate 6. Therefore, the contact area between the lower surface (contact portion 308) of the elastic membrane 307 and the semiconductor wafer W can be kept constant. Then, the top ring 301 and the polishing table 100 are rotated independently of each other while the polishing liquid supply nozzle 102 supplies a polishing liquid Q onto the polishing surface 101a. The polishing liquid Q is held on the polishing surface 101a of the polishing pad 101, and the semiconductor wafer W is polished in the presence of the polishing liquid Q between the (lower) surface, to be polished, of the semiconductor wafer W and the polishing pad 101.

In the present embodiment, even if the pressure of the pressurized fluid is small, the pressure chambers 322, 323, 324 and 325 can be expanded sufficiently. Therefore, it is possible to press the semiconductor wafer W under a small pressing force. Accordingly, in the case where a semiconductor wafer having a low-k material, which has a low dielectric constant and a low hardness, as an interlayer insulator film for Cu interconnections is polished, the semiconductor wafer is polished without causing damage to the low-k material.

With the above structure, since the semiconductor wafer W is polished while the retainer ring 3 is being held in sliding contact with the polishing surface 101a, the retainer ring 3 is worn with time. Thus, a distance between the lower surface of the chucking plate 6 and the semiconductor wafer W becomes small. In a conventional substrate holding apparatus, when the distance between the chucking plate and the semiconductor wafer becomes small, a contact area between the elastic membrane and the semiconductor wafer is changed, thus causing a change in the polishing profile. According to the present embodiment, even in such a situation, the stretchable and contractible portions 340a, 340b, 340c and 340d are contracted upwardly as the retainer ring 3 is worn, thus allowing the contact area between the semiconductor wafer W and the elastic membrane 307 (the contact portion 308) to be kept constant. Therefore, it is possible to prevent the polishing profile from being changed.

Although the integrally formed elastic membrane is employed in the present embodiment, the present invention is not limited to such elastic membrane. An elastic membrane having a plurality of separate portions divided by a circumferentially extending slit formed in the contact portion may be employed. In this case also, the contact area between the semiconductor wafer and the elastic membrane (the contact portion) can be kept constant by providing the stretchable and contractible portions described above. Therefore, it is possible to obtain a uniform polishing rate over the entire polished surface of the semiconductor wafer.

The local areas of the semiconductor wafer W that are positioned beneath the pressure chambers 322, 323, 324 and 325 are pressed against the polishing surface 101a of the polishing pad 101 under the pressures of the pressurized fluids supplied to the pressure chambers 322, 323, 324 and 325. Therefore, the pressures of the pressurized fluids supplied to the pressure chambers 322, 323, 324 and 325 are controlled independently of each other, so that the entire surface of the semiconductor wafer W can be pressed against the polishing pad 101 under a uniform pressing force. As a result, a uniform polishing rate can be obtained over the entire surface of the semiconductor wafer W. In the same manner, the regulator R2 regulates the pressure of the pressurized fluid supplied to the pressure chamber 321 so as to change the pressing force applied to the polishing pad 101 by the retainer ring 3. In this manner, during polishing, the pressing force applied to the polishing pad 101 by the retainer ring 3 and the pressing forces applied by the respective pressure chambers 322, 323, 324 and 325 to press the semiconductor wafer W against the polishing pad 101 are appropriately adjusted so as to control the polishing profile of the semiconductor wafer W.

As described above, the pressing force applied by the top ring air cylinder 111 to press the retainer ring 3 against the polishing pad 101 and the pressing forces applied by the pressurized fluids supplied to the pressure chambers 322, 323, 324 and 325 to press the semiconductor wafer W against the polishing pad 101 are appropriately adjusted to polish the semiconductor wafer W. When the polishing of the semiconductor wafer W is finished, the supply of the pressurized fluids into the pressure chambers 322, 323, 324 and 325 is stopped, and the pressures in the pressure chambers 322, 323, 324 and 325 are reduced to the atmospheric pressure. Then, the pressurized fluid is supplied to the pressure chamber 321 to move the chucking plate 6 downwardly for thereby bringing the contact portion 308 into uniformly intimate contact with the upper surface of the semiconductor wafer W. In this state, the semiconductor wafer W is attracted again to the lower end of the top ring 301 under vacuum. Immediately thereafter, the atmospheric pressure or a negative pressure is produced in the pressure chamber 321. This is because if the pressure chamber 321 is maintained at a high pressure, then the semiconductor wafer W is locally pressed against the polishing surface 101a by the lower surface of the chucking plate 6.

After attraction of the semiconductor wafer W in a manner as described above, the top ring 301 as a whole is moved to a transfer position where the semiconductor wafer W is transferred, and the vacuum attraction through the holes or recesses (not shown) formed in the lower portion of the pressure chamber 323 or the pressure chamber 324 is stopped. Then, the pressure chambers 322, 323, 324 and 325 are supplied with a pressurized fluid having a predetermined pressure, which is ejected through the holes or recesses to the semiconductor wafer W, thereby releasing the semiconductor wafer W.

The polishing liquid Q used to polish the semiconductor wafer W tends to flow into the small gap G between the outer circumferential surface of the elastic membrane 307 and the retainer ring 3. If the polishing liquid Q is firmly deposited on the outer circumferential surface of the elastic membrane 307 and the retainer ring 3, then the holder ring 5, the chucking plate 6, the elastic membrane 307, and the like are prevented from smoothly moving vertically with respect to the top ring body 2 and the retainer ring 3. In order to avoid such a drawback, a cleaning liquid such as pure water is supplied through the fluid passage 30 to the annular cleaning liquid passage 51. Accordingly, the cleaning liquid is supplied through the plurality of the communication holes 53 to a space above the gap G, thus washing out the polishing liquid Q in the gap G to prevent the polishing liquid Q from being firmly deposited in the gap G. The cleaning liquid is preferably supplied after the polished semiconductor wafer W is released and until a next semiconductor wafer to be polished is attracted to the top ring 301.

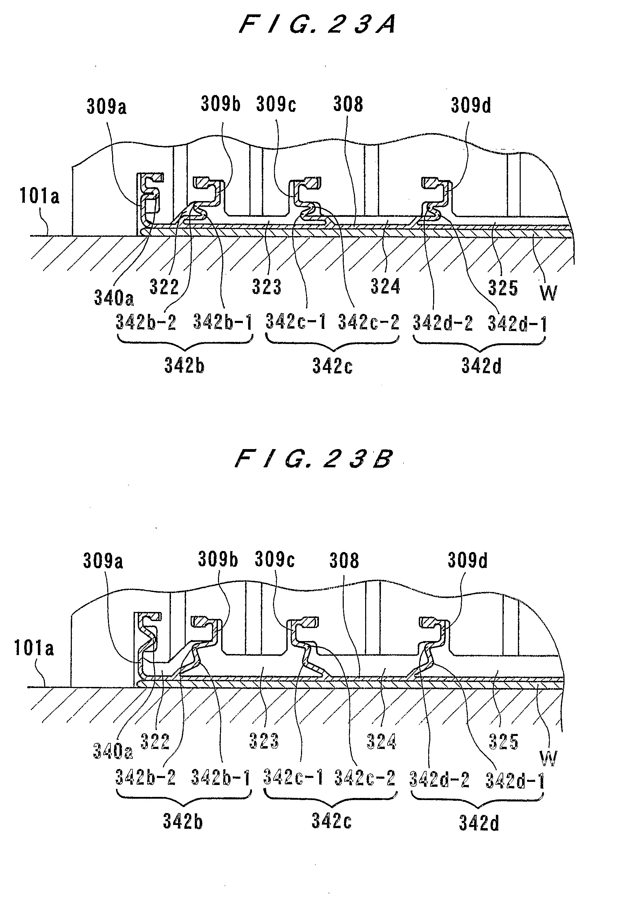

A top ring serving as a substrate holding apparatus according to a fourteenth embodiment of the present invention will be described below with reference to FIGS. 23A and 23B. FIG. 23A is a view showing a part of the top ring according to the fourteenth embodiment of the present invention, and FIG. 23B is a view showing the state in which a fluid is supplied to the pressure chambers. In order to simplify the drawing, structural details other than an elastic membrane are schematically illustrated in FIGS. 23A and 23B. Structural details of the substrate holding apparatus according to the fourteenth embodiment which will not be described below are identical to those of the substrate holding apparatus according to the thirteenth embodiment.

As shown in FIG. 23A, the second circumferential wall 309b has a stretchable and contractible portion 342b which is stretchable and contractible vertically. The stretchable and contractible portion 342b comprises two folded-back portions 342b-1, 342b-2 positioned near the lower end of the second circumferential wall 309b. The folded-back portion 342b-1 projects radially inwardly, and the folded-back portion 342b-2 projects radially outwardly. The third circumferential wall 309c and the fourth circumferential wall 309d also have stretchable and contractible portions 342c, 342d, respectively, which are stretchable and contractible vertically. The stretchable and contractible portion 342c comprises two folded-back portions 342c-1, 342c-2 positioned near the lower end of the third circumferential wall 309c. The folded-back portion 342c-1 projects radially outwardly, and the folded-back portion 342c-2 projects radially inwardly. The stretchable and contractible portion 342d comprises two folded-back portions 342d-1, 342d-2 positioned near the lower end of the fourth circumferential wall 309d. The folded-back portion 342d-1 projects radially inwardly, and the folded-back portion 342d-2 projects radially outwardly.

Since the circumferential walls 309a, 309b, 309c and 309d have the stretchable and contractible portions 340a, 342b, 342c and 342d, respectively, the circumferential walls 309a, 309b, 309c and 309d can be stretched and contracted while the contact portion 308 is being kept in shape. Specifically, the circumferential walls 309a, 309b, 309c and 309d including the respective stretchable and contractible portions 340a, 342b, 342c and 342d can be stretched uniformly in the vertical direction. Therefore, as shown in FIG. 23B, when a pressurized fluid is supplied to the pressure chambers 322, 323, 324 and 325 to move the chucking plate 6 (see FIG. 21) upwardly, the stretchable and contractible portions 340a, 342b, 342c and 342d are stretched so as to follow the movement of the chucking plate 6. Consequently, a contact area between the elastic membrane 307 (the contact portion 308) and the semiconductor wafer W can be kept constant.

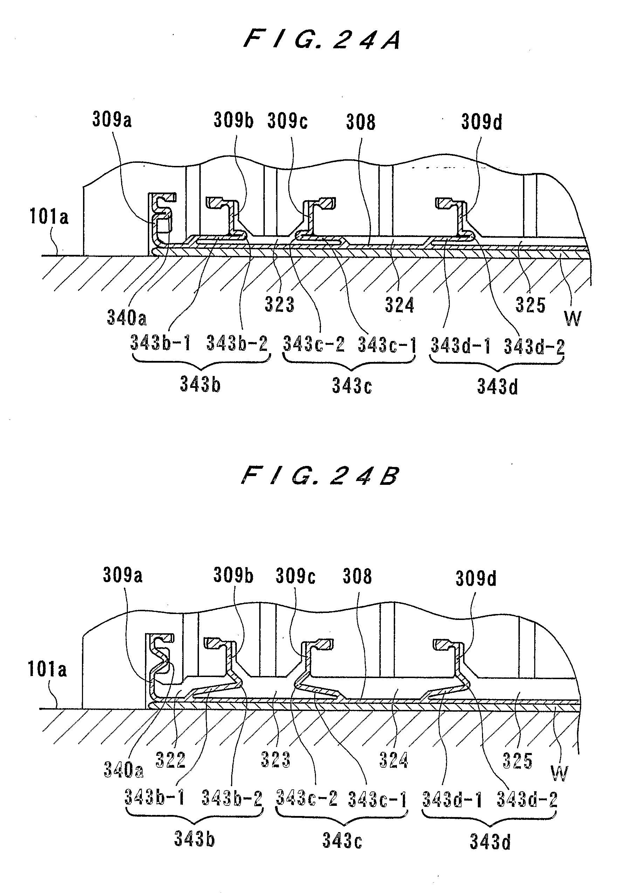

A top ring serving as a substrate holding apparatus according to a fifteenth embodiment will be described below with reference to FIGS. 24A and 24B. FIG. 24A is a view showing a part of the top ring according to the fifteenth embodiment, and FIG. 24B is a view showing the state in which a fluid is supplied to the pressure chambers. In order to simplify the drawing, structural details other than an elastic membrane are schematically illustrated in FIGS. 24A and 24B. Structural details of the substrate holding apparatus according to the fifteenth embodiment of which will not be described below are identical to those of the substrate holding apparatus according to the thirteenth embodiment.

As shown in FIG. 24A, the second circumferential wall 309b has a stretchable and contractible portion 343b which is stretchable and contractible vertically. The stretchable and contractible portion 343b comprises a horizontal portion 343b-1 extending radially outwardly and positioned near the lower end of the second circumferential wall 309b, and a folded-back portion 343b-2 connected integrally to an inner end of the horizontal portion 343b-1 and projecting radially inwardly. The third circumferential wall 309c and the fourth circumferential wall 309d also have stretchable and contractible portions 343c, 343d, respectively, which are stretchable and contractible vertically. The stretchable and contractible portion 343c comprises a horizontal portion 343c-1 extending radially inwardly and positioned near the lower end of the third circumferential wall 309c, and a folded-back portion 343c-2 connected integrally to an outer end of the horizontal portion 343c-1 and projecting radially outwardly. The stretchable and contractible portion 343d comprises a horizontal portion 343d-1 extending radially outwardly and positioned near the lower end of the fourth circumferential wall 309d, and a folded-back portion 343d-2 connected integrally to an inner end of the horizontal portion 343d-1 and projecting radially inwardly.

Since the circumferential walls 309a, 309b, 309c and 309d have the stretchable and contractible portions 340a, 343b, 343c and 343d, respectively, the circumferential walls 309a, 309b, 309c and 309d can be stretched and contracted while the contact portion 308 is being kept in shape. Specifically, the circumferential walls 309a, 309b, 309c and 309d including the respective stretchable and contractible portions 340a, 343b, 343c and 343d can be stretched uniformly in the vertical direction. Therefore, as shown in FIG. 24B, when a pressurized fluid is supplied to a pressure chambers 322, 323, 324 and 325 to move the chucking plate 6 (see FIG. 21) upwardly, the stretchable and contractible portions 340a, 343b, 343c and 343d are stretched so as to follow the movement of the chucking plate 6. Consequently, a contact area between the elastic membrane 307 (the contact portion 308) and the semiconductor wafer W can be kept constant.

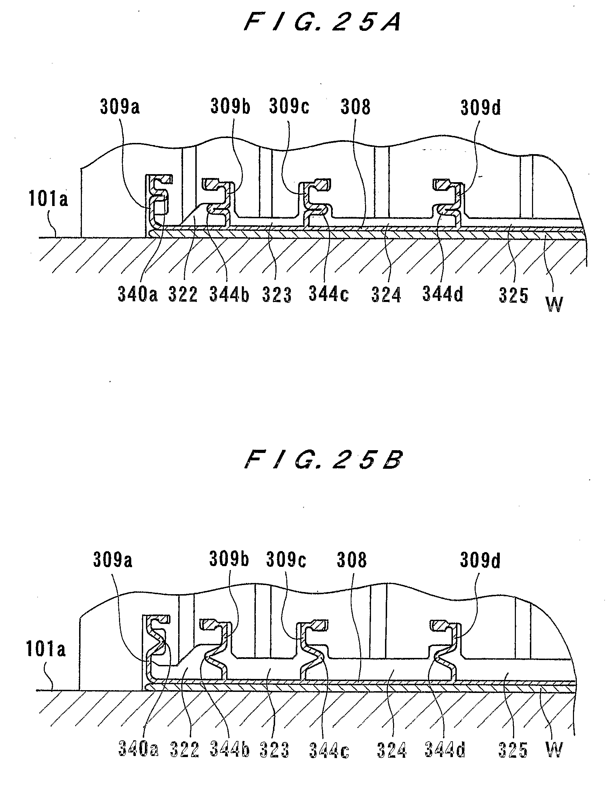

A top ring serving as a substrate holding apparatus according to a sixteenth embodiment will be described below with reference to FIGS. 25A and 25B. FIG. 25A is a view showing a part of the top ring according to the sixteenth embodiment, and FIG. 25B is a view showing the state in which a fluid is supplied to the pressure chambers. In order to simplify the drawing, structural details other than an elastic membrane are schematically illustrated in FIGS. 25A and 25B. Structural details of the substrate holding apparatus according to the sixteenth embodiment which will not be described below are identical to those of the substrate holding apparatus according to the thirteenth.

As shown in FIG. 25A, the second circumferential wall 309b has a stretchable and contractible portion 344b which is stretchable and contractible vertically. The stretchable and contractible portion 344b comprises a folded-back portion projecting radially outwardly and positioned in a substantially central region of the second circumferential wall 309b. The third circumferential wall 309c and the fourth circumferential wall 309d also have stretchable and contractible portions 344c, 344d, respectively, which are stretchable and contractible vertically. The stretchable and contractible portion 344c comprises a folded-back portion projecting radially inwardly and positioned in a substantially central region of the third circumferential wall 309c. The stretchable and contractible portion 344d comprises a folded-back portion projecting radially outwardly and positioned in a substantially central region of the fourth circumferential wall 309d.

Since the circumferential walls 309a, 309b, 309c and 309d have the stretchable and contractible portions 340a, 344b, 344c and 344d, respectively, the circumferential walls 309a, 309b, 309c and 309d can be stretched and contracted while the contact portion 308 is being kept in shape. Specifically, the circumferential walls 309a, 309b, 309c and 309d including the respective stretchable and contractible portions 340a, 344b, 344c and 344d can be stretched uniformly in the vertical direction. Therefore, as shown in FIG. 25B, when a pressurized fluid is supplied to the pressure chambers 322, 323, 324 and 325 to move the chucking plate 6 (see FIG. 21) upwardly, the stretchable and contractible portions 340a, 344b, 344c and 344d are stretched so as to follow the movement of the chucking plate 6. Consequently, a contact area between the elastic membrane 307 (the contact portion 308) and the semiconductor wafer W can be kept constant.

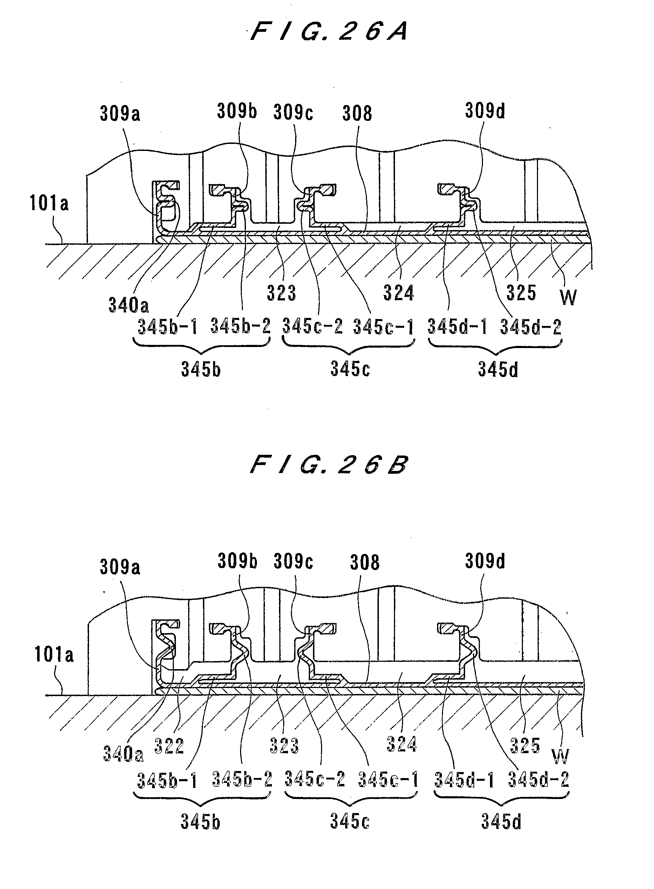

A top ring serving as a substrate holding apparatus according to a seventeenth embodiment will be described below with reference to FIGS. 26A and 26B. FIG. 26A is a view showing a part of the top ring according to the seventeenth embodiment, and FIG. 26B is a view showing the state in which a fluid is supplied to the pressure chambers. In order to simplify the drawing, structural details other than an elastic membrane are schematically illustrated in FIGS. 26A and 26B. Structural details of the substrate holding apparatus according to the seventeenth embodiment which will not be described below are identical to those of the substrate holding apparatus according to the thirteenth embodiment.

As shown in FIG. 26A, the second circumferential wall 309b has a stretchable and contractible portion 345b which is stretchable and contractible vertically. The stretchable and contractible portion 345b comprises a horizontal portion 345b-1 extending radially outwardly and positioned near the lower end of the second circumferential wall 309b, and a folded-back portion 345b-2 projecting radially inwardly and positioned in a substantially central region of the second circumferential wall 309b. The third circumferential wall 309c and the fourth circumferential wall 309d also have stretchable and contractible portions 345c, 345d, respectively, which are stretchable and contractible vertically. The stretchable and contractible portion 345c comprises a horizontal portion 345c-1 extending radially inwardly and positioned near the lower end of the third circumferential wall 309c, and a folded-back portion 345c-2 projecting radially outwardly and positioned in a substantially central region of the third circumferential wall 309c. The stretchable and contractible portion 345d comprises a horizontal portion 345d-1 extending radially outwardly and positioned near the lower end of the fourth circumferential wall 309d, and a folded-back portion 345d-2 projecting radially inwardly and positioned in a substantially central region of the fourth circumferential wall 309d.

Since the circumferential walls 309a, 309b, 309c and 309d have the stretchable and contractible portions 340a, 345b, 345c and 345d, respectively, the circumferential walls 309a, 309b, 309c and 309d can be stretched and contracted while the contact portion 308 is being kept in shape. Specifically, the circumferential walls 309a, 309b, 309c and 309d including the respective stretchable and contractible portions 340a, 345b, 345c and 345d can be stretched uniformly in the vertical direction. Therefore, as shown in FIG. 26B, when a pressurized fluid is supplied to the pressure chambers 322, 323, 324 and 325 to move the chucking plate 6 (see FIG. 21) upwardly, the stretchable and contractible portions 340a, 345b, 345c and 345d are stretched so as to follow the movement of the chucking plate 6. Consequently, a contact area between the elastic membrane 307 (the contact portion 308) and the semiconductor wafer W can be kept constant.

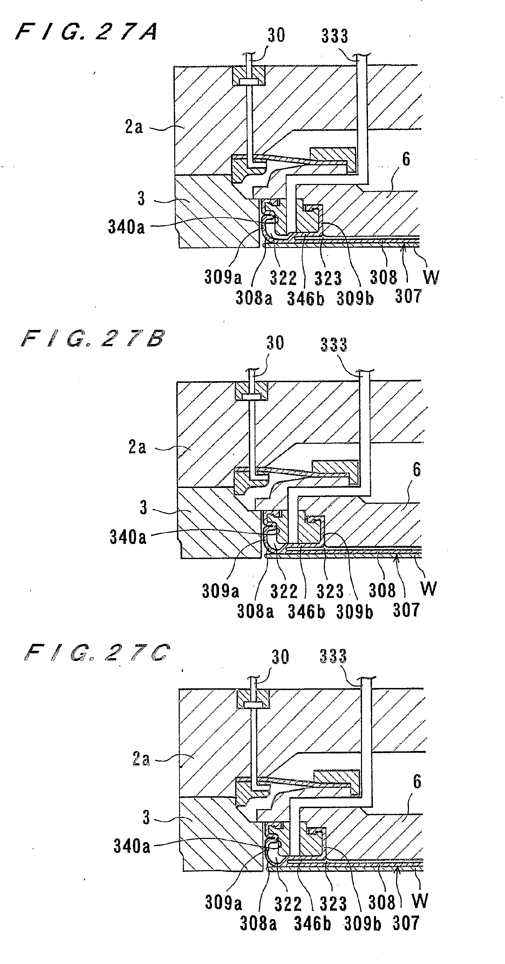

A top ring serving as a substrate holding apparatus according to an eighteenth embodiment will be described below with reference to FIGS. 27A through 27C. FIG. 27A is an enlarged fragmentary cross-sectional view showing a first example of the top ring according to the eighteenth embodiment FIG. 27B is an enlarged fragmentary cross-sectional view showing a second example of the top ring according to the eighteenth embodiment, and FIG. 27C is an enlarged fragmentary cross-sectional view showing a third example of the top ring according to the eighteenth embodiment. Structural details of the substrate holding apparatus according to the eighteenth embodiment which will not be described below are identical to those of the substrate holding apparatus according to the thirteenth embodiment.

As shown in FIG. 27A, an inclined portion 308a inclining upwardly is formed in the outer circumferential edge of the contact portion 308 of the elastic membrane 307. The inclined portion 308a has a curved cross section. With this structure, even when a pressurized fluid is supplied to the pressure chambers 322, 323 so as to lift the chucking plate 6, the contact portion 308 of the elastic membrane 307 and the outer circumferential edge of the semiconductor wafer W can be kept out of contact with each other. Therefore, the elastic membrane 307 does not apply a pressing force to the outer circumferential edge of the semiconductor wafer W. Consequently, so-called "edge rounding" in which the outer circumferential edge of the semiconductor wafer W is excessively polished is prevented from occurring.

A space between the inclined portion 308a and the semiconductor wafer W should preferably be as small as possible because the polishing liquid tends to be retained in the space. Accordingly, the inclined portion 308a should preferably have a vertical dimension smaller than a horizontal dimension thereof. In the present embodiment, the second circumferential wall 309b has a stretchable and contractible portion 346b. The stretchable and contractible portion 346b comprises a horizontal portion extending radially outwardly and positioned near the lower end of the second circumferential wall 309b. The second circumferential wall 309b may further have a folded-back portion shown in the thirteenth through seventeenth embodiments.

The second example shown in FIG. 27B is different from the first example shown in FIG. 27A in a position of the second circumferential wall 309b. Specifically, the lower end of the second circumferential wall 309b is positioned closely to the first circumferential wall 309a, and the inclined portion 308a extends upwardly from the lower end of the second circumferential wall 309b. Therefore, the pressure in the pressure chamber 323 can be applied to a region of the semiconductor wafer W which is located radially inwardly of the outer circumferential edge of the semiconductor wafer W.

The third example shown in FIG. 27C is different from the second example shown in FIG. 27B in a thickness of the inclined portion 308a. Specifically, in the third example, the inclined portion 308a is thinner than a horizontal portion of the contact portion 308. Therefore, when a pressurized fluid is supplied to the pressure chamber 322, the inclined portion 308a can be easily expanded to press only the outer circumferential edge of the semiconductor wafer W against the polishing surface 101a (see FIG. 1) under a desired pressing force. As a result, a polishing rate at the outer circumferential edge of the semiconductor wafer W can independently be controlled.

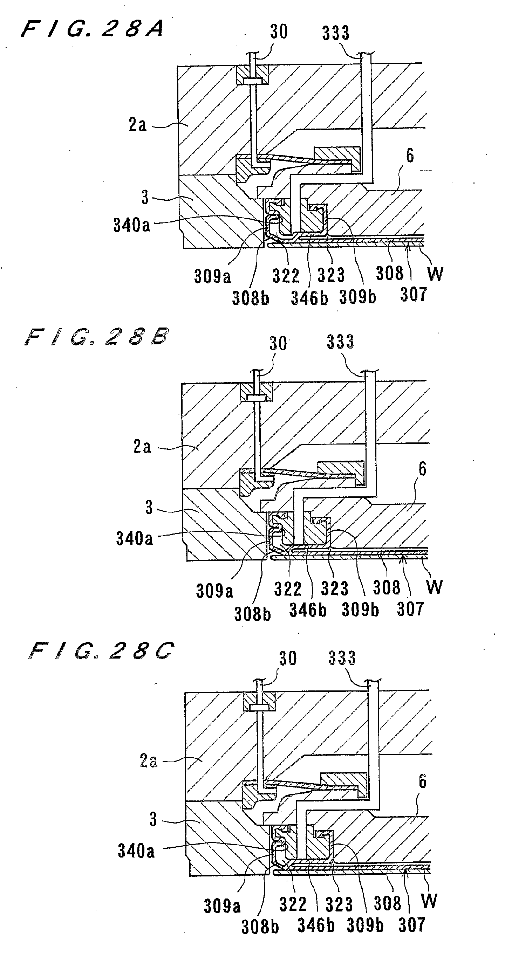

A top ring serving as a substrate holding apparatus according to a nineteenth embodiment will be described below with reference to FIGS. 28A through 28C. FIG. 28A is an enlarged fragmentary cross-sectional view showing a first example of the top ring according to the nineteenth embodiment, FIG. 28B is an enlarged fragmentary cross- sectional view showing a second example of the top ring according to the nineteenth embodiment of the present invention, and FIG. 28C is an enlarged fragmentary cross-sectional view showing a third example of the top ring according to the nineteenth embodiment. Structural details and advantages of the substrate holding apparatus according to the nineteenth embodiment which will not be described below are identical to those of the substrate holding apparatus according to the thirteenth and eighteenth embodiments.

As shown in FIG. 28A, an inclined portion 308b inclining upwardly is formed in the outer circumferential edge of the contact portion 308 of the elastic membrane 307. The inclined portion 308b has a straight cross section. With this structure, even when a pressurized fluid is supplied to the pressure chambers 322, 323 to lift the chucking plate 6, the contact portion 308 of the elastic membrane 307 and the outer circumferential edge of the semiconductor wafer W can be kept out of contact with each other. In order to reduce a space between the inclined portion 308b and the semiconductor wafer W, the inclined portion 308b should preferably have a vertical dimension smaller than a horizontal dimension thereof.

The lower end of the second circumferential wall 309b shown in FIG. 28B is positioned closely to the first circumferential wall 309a. The inclined portion 308b extends upwardly from the lower end of the second circumferential wall 309b. Therefore, the pressure produced in the pressure chamber 323 can be applied to the region of the semiconductor wafer W which is located radially inwardly of the outer circumferential edge of the semiconductor wafer W.

In the third example shown in FIG. 28C, the inclined portion 308b is thinner than a horizontal portion of the contact portion 308. Therefore, when a pressurized fluid is supplied to the pressure chamber 322, the inclined portion 308b can be easily expanded to press only the outer circumferential edge of the semiconductor wafer W against the polishing surface 101a (see FIG. 1) under a desired pressing force. As a result, a polishing rate of the outer circumferential edge of the semiconductor wafer W can independently be controlled.

During the polishing process, the lower end of the retainer ring 3 is gradually worn due to sliding contact with the polishing surface 101a. Therefore, a distance between the chucking plate 6 and the semiconductor wafer W becomes small, and hence a contact area between the elastic membrane 307 and the semiconductor wafer W is changed. Consequently, the polishing rate tends to be locally changed. In order to prevent such a problem from occurring, it is preferable that the stretchable and contractible portions 340a to 340d, 341b to 341d, 342b to 342d, 343b to 343d, 344b to 344d, 345b to 345d, and 346b are stretchable and contractible to a degree greater than an amount of wear on the retainer ring 3. Thus, the stretchable and contractible portions can be contracted upwardly as the retainer ring 3 is worn, thus preventing the polishing rate from being locally changed.

As described above, since the stretchable and contractible portion is stretched perpendicularly to the polishing surface as the fluid is supplied to the pressure chamber, the contact portion of the elastic membrane can be kept in shape. Therefore, the contact area between the elastic membrane (the contact portion) and the substrate can be kept constant, and hence a uniform polishing rate can be obtained over the entire polished surface of the substrate. The stretchable and contractible portion is effective to allow the elastic membrane and the substrate to be kept in sufficient contact with each other. Therefore, it is possible to use an elastic membrane having a high hardness, thus enabling the elastic membrane to be increased in durability. In this case, the elastic membrane having a high hardness can maintain the contact area between the substrate and the elastic membrane (the contact portion), compared to an elastic membrane having a low hardness. Thus, a stable polishing rate can be obtained.

### Industrial Applicability

The present invention is applicable to a substrate holding apparatus for holding a substrate to be polished and pressing the substrate against a polishing surface, and more particularly to a substrate holding apparatus for holding a substrate such as a semiconductor wafer in a polishing apparatus for polishing the substrate to a flat finish. The present invention is also applicable to a polishing apparatus having such a substrate holding apparatus.

## Claims

1. A substrate holding apparatus (301) for holding and pressing a substrate (W) to be polished against a polishing surface (101 a), said substrate holding apparatus (301) comprising:
a retainer ring (3) configured to press the polishing surface;
a movable member (5, 6) which is movable perpendicularly to the polishing surface (101a) and is movable relative to said retainer ring (3); and
an elastic membrane (307) connected to said movable member (5, 6) for defining a plurality of pressure chambers (322, 323, 324, 325); **characterized in that**
said elastic membrane (307) comprises a contact portion (308) which is brought
into contact with the substrate (W), and a plurality of circumferential walls (309a, 309b, 309c, 309d) for connecting said contact portion (308) to said movable member (5, 6), each of said plurality of circumferential walls (309a, 309b, 309c, 309d) having a folded portion to form a stretchable and contractible portion (340a to 340d, 341 b to 341 d, 342b to 342d, 343b to 343d, 344b to 344d, 345b to 345d, and 346b) which is stretchable and contractible perpendicularly to the polishing surface (101a).

2. The substrate holding apparatus according to claim 1, wherein said folded portion has a substantially arcuate cross section.

3. The substrate holding apparatus according to claim 1, wherein said stretchable and contractible portion (340a to 340d, 341 b to 341 d, 342b to 342d, 343b to 343d, 344b to 344d, 345b to 345d, and 346b) is made of a material softer than said contact portion (308).

4. The substrate holding apparatus according to claim 1, wherein at least one of said circumferential walls (309a, 309b, 309c, 309d) has a portion that is thinner than said contact portion (308) to form said stretchable and contractible portion.

5. The substrate holding apparatus according to any one of claims 1 to 4, wherein at least one of said circumferential walls (309a, 309b, 309c, 309d) has a portion made of a material harder than said contact portion (308) and positioned below said stretchable and contractible portion.

6. The substrate holding apparatus according to any one of claims 1 to 4, wherein at least one of said circumferential walls (309a, 309b, 309c, 309d) has a portion which is thicker than said contact portion (308) and positioned below said stretchable and contractible portion.

7. The substrate holding apparatus according to any one of claims 1 to 4, wherein a hard member harder than said elastic membrane (307) is embedded in at least one of said circumferential walls (309a, 309b, 309c, 309d), and said hard member is positioned below said stretchable and contractible portion.

8. The substrate holding apparatus according to any one of claims 1 to 4, wherein a hard member harder than said elastic membrane (307) is fixed to at least one of said circumferential walls (309a, 309b, 309c, 309d), and said hard member is positioned below said stretchable and contractible portion.

9. The substrate holding apparatus according to any one of claims 1 to 4, wherein at least one of said circumferential walls (309a, 309b, 309c, 309d) has a portion whose surface is coated with a hard material that is harder than said elastic membrane (307), and said portion is positioned below said stretchable and contractible portion.

10. The substrate holding apparatus according to any one of claims 1 to 9, further comprising a pressing member which is brought into contact with an upper surface of said contact portion (308) so as to press said contact portion against the substrate (W).

11. The substrate holding apparatus according to claim 10, wherein said pressing member has a plurality of grooves formed in a lower surface thereof and extending radially.

12. The substrate holding apparatus according to claim 10, wherein said pressing member has a fluid supply port formed in a lower surface thereof for supplying a fluid to the upper surface of said contact portion.

13. The substrate holding apparatus according to any one of claims 10 to 12,
wherein said contact portion (308) has a thick portion formed on the upper surface thereof and extending in a circumferential direction of said contact portion (308).

14. The substrate holding apparatus according to claim 13, wherein said thick portion has a substantially triangular or arcuate cross section.

15. The substrate holding apparatus according to any one of claims 10 to 14,
wherein a reinforcement member is embedded in said contact portion (308).

16. The substrate holding apparatus according to any one of claims 1 to 15, wherein said contact portion (308) has a plurality of convexities and concavities formed on an upper surface thereof.

17. The substrate holding apparatus according to any one of the preceding claims, wherein said elastic membrane (307) has an integral structure.

18. The substrate holding apparatus according to any one of the preceding claims, wherein said contact portion (308) has an inclined portion (308a) disposed on an outer edge thereof and inclined upwardly.

19. The substrate holding apparatus according to any one of the preceding claims, wherein said inclined portion (308a) has a curved cross section.

20. The substrate holding apparatus according to any one claims 1 to 18, wherein said inclined portion (308a) has a straight cross section.

21. The substrate holding apparatus according to any one of claims 1 to 20, wherein said inclined portion (308a) is thinner than said contact portion (308).

22. The substrate holding apparatus according to any one of the preceding claims, wherein said contact portion (308) has a removal promoting portion for promoting removal of said contact portion (308) from the substrate.

23. The substrate holding apparatus according to claim 22, wherein said removal promoting portion comprises a notch formed in a circumferential edge of said contact portion (308).

24. The substrate holding apparatus according to claim 22 or 23, wherein said contact portion (308) has a region made of a material having a lower adhesiveness to the substrate than that of said elastic membrane (307).

25. The substrate holding apparatus according to any one of claims 22 to 24,
wherein a surface of said contact portion (308) has a plurality of convexities and concavities.

26. The substrate holding apparatus according to claim 22, wherein said elastic membrane (307) comprises a plurality of contact portions (308), and said removal promoting portion
comprises an interconnecting portion for interconnecting one of said plurality of contact portions and another of said plurality of contact portions.

27. The substrate holding apparatus according to claim 22, wherein said removal promoting portion comprises an upwardly concave recess formed in said contact portion (308), and said recess is brought into intimate contact with the substrate when a pressurized fluid is supplied to said pressure chamber.

28. A polishing apparatus comprising:
a substrate holding apparatus (301) according to any one of claims 1 to 27; and
a polishing table (100) having a polishing surface (101 a).

29. A method of polishing a substrate, comprising:
holding the substrate by a substrate holding apparatus according to any one of claims 1 to 27;
placing the substrate onto a polishing surface of a polishing table;
moving said vertically movable member downwardly to press said contact portion against the substrate;
supplying a pressurized fluid to said pressure chamber while pressing said contact portion against the substrate; and
bringing the substrate into sliding contact with said polishing surface so as to polish the substrate.

## Patentansprüche

1. Substrathaltevorrichtung (301) zum Halten und Drücken eines zu polierenden Substrats (W) gegen eine Polieroberfläche (101a), wobei die Substrathaltevorrichtung (301) folgendes aufweist:
einen Haltering (3), der konfiguriert ist gegen die Polieroberfläche zu drücken;
ein bewegbares Glied (5, 6), das senkrecht zur Polieroberfläche (101 a) bewegbar ist und das relativ zum Haltering (3) bewegbar ist; und
eine elastische Membran (307), die mit dem bewegbaren Glied (5, 6) verbunden ist zum Definieren einer Vielzahl von Druckkammern (322, 323, 324, 325);
**dadurch gekennzeichnet, dass**
die elastische Membran (307) Folgendes aufweist:
einen Kontaktteil (308), der in Kontakt mit dem Substrat (W) gebracht wird und eine Vielzahl von Umfangswänden (309a, 309b, 309c, 309d) zum Verbinden des Kontaktteils (308) mit dem bewegbaren Glied (5, 6), wobei jede der Vielzahl von Umfangswänden (309a, 309b, 309c, 309d) einen gefalteten Teil aufweist zum Ausbilden eines ausziehbaren und zusammenziehbaren Teils (340a bis 340d, 341 b bis 341d, 342b bis 342d, 343b bis 343d, 344b bis 344d, 345b bis 345d und 346b), der senkrecht zur Polieroberfläche (101 a) ausziehbar und zusammenziehbar ist.

2. Substrathaltevorrichtung nach Anspruch 1, wobei der gefaltete Teil einen im Wesentlichen bogenförmigen Querschnitt aufweist.

3. Substrathaltevorrichtung nach Anspruch 1, wobei der auszieh- und zusammenziehbare Teil (340a bis 340d, 341b bis 341d, 342b bis 342d, 343b bis 343d, 344b bis 344d, 345b bis 345d und 346b) aus einem Material besteht, das weicher ist als der Kontaktteil (308).

4. Substrathaltevorrichtung nach Anspruch 1, wobei wenigstens eine der Umfangswände (309a, 309b, 309c, 309d) einen Teil aufweist, der dünner ist als der Kontaktteil (308), um den auszieh- und zusammenziehbaren Teil zu bilden.

5. Substrathaltevorrichtung nach einem der Ansprüche 1 bis 4, wobei wenigstens eine der Umfangswände (309a, 309b, 309c, 309d) einen Teil aufweist, der aus einem Material besteht, das härter ist als der Kontaktteil (308) und der unterhalb des auszieh- und zusammenziehbaren Teils positioniert ist.

6. Substrathaltevorrichtung nach einem der Ansprüche 1 bis 4, wobei wenigstens eine der Umfangswände (309a, 309b, 309c, 309d) einen Teil aufweist, der dicker ist als der Kontaktteil (308) und der unterhalb des auszieh- und zusammenziehbaren Teils positioniert ist.

7. Substrathaltevorrichtung nach einem der Ansprüche 1 bis 4, wobei ein hartes Glied, das härter ist als die elastische Membran (307) in wenigstens einer der Umfangswände (309a, 309b, 309c, 309d) eingebettet ist, und wobei das harte Glied unterhalb des auszieh- und zusammenziehbaren Teils positioniert ist.

8. Substrathaltevorrichtung nach einem der Ansprüche 1 bis 4, wobei ein hartes Glied, das härter ist als die elastische Membran (307) an wenigstens einer der Umfangswände (309a, 309b, 309c, 309d) befestigt ist, und wobei das harte Glied unterhalb des auszieh- und zusammenziehbaren Teils positioniert ist.

9. Substrathaltevorrichtung nach einem der Ansprüche 1 bis 4, wobei wenigstens eine der Umfangswände (309a, 309b, 309c, 309d) einen Teil aufweist, dessen Oberfläche mit einem harten Material beschichtet ist, das härter ist als die elastische Membran (307), und wobei der Teil unterhalb des auszieh- und zusammenziehbaren Teil positioniert ist.

10. Substrathaltevorrichtung nach einem der Ansprüche 1 bis 9, das ferner ein Andrückglied aufweist, das in Kontakt mit einer Oberseite des Kontaktteils (308) gebracht wird, um den Kontaktteil gegen das Substrat (W) zu drücken.

11. Substrathaltevorrichtung nach Anspruch 10, wobei das Andrückglied eine Vielzahl von Nuten aufweist, die in einer Unterseite davon angeordnet sind und sich radial erstrecken.

12. Substrathaltevorrichtung nach Anspruch 10, wobei das Andrückglied einen Fluidversorgungsanschluss aufweist, der in einer Unterseite davon ausgebildet ist zum Liefern eines Fluids an die Oberseite des Kontaktteils.

13. Substrathaltevorrichtung nach einem der Ansprüche 10 bis 12, wobei der Kontaktteil (308) einen dicken Abschnitt aufweist, der an der Oberseite davon ausgebildet ist und sich in einer Umfangsrichtung des Kontaktteils (308) erstreckt.

14. Substrathaltevorrichtung nach Anspruch 13, wobei der dicke Abschnitt einen im Wesentlichen dreieckigen oder gebogenen Querschnitt aufweist.

15. Substrathaltevorrichtung nach einem der Ansprüche 10 bis 14, wobei ein Verstärkungsglied in dem Kontaktteil (308) eingebettet ist.

16. Substrathaltevorrichtung nach einem der Ansprüche 1 bis 15, wobei der Kontaktteil (308) eine Vielzahl von konvexen und konkaven Formen besitzt, die an einer Oberseite davon ausgebildet sind.

17. Substrathaltevorrichtung nach einem der vorherigen Ansprüche, wobei die elastische Membran (307) eine integrale Struktur aufweist.

18. Substrathaltevorrichtung nach einem der vorherigen Ansprüche, wobei der Kontaktteil (308) einen geneigten Abschnitt (308a) aufweist, der an einer Außenkante davon angeordnet ist und der nach oben geneigt ist.

19. Substrathaltevorrichtung nach einem der vorherigen Ansprüche, wobei der geneigte Teil (308a) einen gekrümmten Querschnitt aufweist.

20. Substrathaltevorrichtung nach einem der Ansprüche 1 bis 18, wobei der geneigte Teil (308a) einen geraden Querschnitt aufweist.

21. Substrathaltevorrichtung nach einem der Ansprüche 1 bis 20, wobei der geneigte Teil (308a) dünner ist als der Kontaktteil (308).

22. Substrathaltevorrichtung nach einem der vorherigen Ansprüche, wobei der Kontaktteil (308) einen Entnahmeförderteil aufweist zum Fördern der Entfernung des Kontaktteils (308) von dem Substrat.

23. Substrathaltevorrichtung nach Anspruch 22, wobei der Entfernungsförderteil eine Nut bzw. Kerbe aufweist, die in einer Umfangskante des Kontaktteils (308) ausgebildet ist.

24. Substrathaltevorrichtung nach Anspruch 22 oder 23, wobei der Kontaktteil (308) einen Bereich besitzt, der aus einem Material mit einer geringeren Adhäsivität gegenüber dem Substrat aufweist, als die der elastischen Membran (307).

25. Substrathaltevorrichtung nach einem der Ansprüche 22 bis 24, wobei eine Oberfläche des Kontaktteils (308) eine Vielzahl von konvexen und konkaven Formen besitzt.

26. Substrathaltevorrichtung nach Anspruch 22, wobei die elastische Membran (307) eine Vielzahl von Kontaktteilen (308) aufweist und der Entfernungsförderteil einen Zwischenverbindungsteil aufweist für eine Zwischenverbindung einer der Vielzahl von Kontaktteilen mit einer anderen der Vielzahl von Kontaktteilen.

27. Substrathaltevorrichtung nach Anspruch 22, wobei der Entfernungsförderteil eine nach oben konkave Ausnehmung aufweist, die in dem Kontaktteil (308) ausgebildet ist und wobei die Ausnehmung in intimem Kontakt mit dem Substrat gebracht wird, wenn ein Druckfluid an die Druckkammer angelegt wird.

28. Poliervorrichtung, die folgendes aufweist:
eine Substrathaltevorrichtung (301) gemäß einem der Ansprüche 1 bis 27 und einen Poliertisch (100) mit einer Polieroberfläche (101 a).

29. Verfahren zum Polieren eines Substrats, das folgendes aufweist:
Halten des Substrats durch eine Substrathaltevorrichtung gemäß einem der Ansprüche 1 bis 27;
Platzieren des Substrats auf einer Polieroberfläche eines Poliertisches;
Bewegen des vertikal bewegbaren Gliedes nach unten, um den Kontaktteil gegen das Substrat zu drücken;
Liefern eines unter Druck stehenden Fluids an die Druckkammer während der Kontaktteil gegen das Substrat gedrückt wird; und
Bringen des Substrats in Gleitkontakt mit der Polieroberfläche, um das Substrat zu polieren.

## Revendications

1. Dispositif de maintien de substrat (301), pour maintenir et presser un substrat (W) à polir contre une surface de polissage (101a), le dispositif de maintien de substrat (301) comprenant :
une bague de retenue (3) agencée pour presser la surface de polissage ;
un élément mobile (5, 6) qui est mobile perpendiculairement à la surface de polissage (101a) et est mobile par rapport à la bague de retenue (3) ; et
une membrane élastique (307) connectée à l'élément mobile (5, 6) pour définir une pluralité de chambres de pression (322, 323, 324, 325) ;
**caractérisé en ce que**
la membrane élastique (307) comprend une portion de contact (308) qui est amenée en contact avec le substrat (W), et une pluralité de parois circonférentielles (309a, 309b, 309c, 309d) pour connecter la portion de contact (308) à l'élément mobile (5, 6), chacune de la pluralité de parois circonférentielles (309a, 309b, 309c, 309d) comportant une portion pliée pour former une portion pouvant être étirée et contractée (340a à 340d, 341b à 341d, 342b à 342d, 343b à 343d, 344b à 344d, 345b à 345d, et 346b) qui peut être étirée et contractée perpendiculairement à la surface de polissage (101a).

2. Dispositif de maintien de substrat selon la revendication 1, dans lequel la portion pliée a une section sensiblement cintrée.

3. Dispositif de maintien de substrat selon la revendication 1, dans lequel la portion pouvant être étirée et contractée (340a à 340d, 341b à 341d, 342b à 342d, 343b à 343d, 344b à 344d, 345b à 345d, et 346b), est en un matériau plus doux que la portion de contact (308).

4. Dispositif de maintien de substrat selon la revendication 1, dans lequel au moins l'une des parois circonférentielles (309a, 309b, 309c, 309d) comporte une portion qui est plus mince que la portion de contact (308) pour former la portion pouvant être étirée et contractée.

5. Dispositif de maintien de substrat selon l'une quelconque des revendications 1 à 4, dans lequel au moins l'une des parois circonférentielles (309a, 309b, 309c, 309d) comporte une portion en un matériau plus dur que la portion de contact (308) et positionnée en dessous de la portion pouvant être étirée et contractée.

6. Dispositif de maintien de substrat selon l'une quelconque des revendications 1 à 4, dans lequel au moins l'une des parois circonférentielles (309a, 309b, 309c, 309d) comporte une portion qui est plus épaisse que la portion de contact (308) et est positionnée en dessous de la portion pouvant être étirée et contractée.

7. Dispositif de maintien de substrat selon l'une quelconque des revendications 1 à 4, dans lequel un élément dur plus dur que la membrane élastique (307) est intégré dans au moins l'une des parois circonférentielles (309a, 309b, 309c, 309d), et l'élément dur est disposé en dessous de la portion pouvant être étirée et contractée.

8. Dispositif de maintien de substrat selon l'une quelconque des revendications 1 à 4, dans lequel un élément dur plus dur que la membrane élastique (307) est fixé à au moins l'une des parois circonférentielles (309a, 309b, 309c, 309d), et l'élément dur est disposé en dessous de la portion pouvant être étirée et contractée.

9. Dispositif de maintien de substrat selon l'une quelconque des revendications 1 à 4, dans lequel au moins l'une des parois circonférentielles (309a, 309b, 309c, 309d) comporte une portion dont la surface est revêtue d'un matériau dur qui est plus dur que la membrane élastique (307), et ladite portion est disposée en dessous de la portion pouvant être étirée et contractée.

10. Dispositif de maintien de substrat selon l'une quelconque des revendications 1 à 9, comprenant en outre un élément de pression qui est amené en contact avec une surface supérieure de la portion de contact (308) de façon à presser la portion de contact contre le substrat (W).

11. Dispositif de maintien de substrat selon la revendication 10, dans lequel l'élément de pression comporte une pluralité de gorges formées dans une surface inférieure et s'étendant radialement.

12. Dispositif de maintien de substrat selon la revendication 10, dans lequel l'élément de pression comporte un accès de fourniture de fluide formé dans une surface inférieure pour fournir un fluide à la surface supérieure de la portion de contact.

13. Dispositif de maintien de substrat selon l'une quelconque des revendications 10 à 12, dans lequel la portion de contact (308) comporte une portion épaisse formée sur sa surface supérieure et s'étendant dans une direction circonférentielle de la portion de contact (308).

14. Dispositif de maintien de substrat selon la revendication 13, dans lequel la portion épaisse a une section sensiblement triangulaire ou cintrée.

15. Dispositif de maintien de substrat selon l'une quelconque des revendications 10 à 14, dans lequel un élément de renfort est intégré dans la portion de contact (308).

16. Dispositif de maintien de substrat selon l'une quelconque des revendications 1 à 15, dans lequel la portion de contact (308) comporte une pluralité de convexités et de concavités formées sur une surface supérieure.

17. Dispositif de maintien de substrat selon l'une quelconque des revendications précédentes, dans lequel la membrane élastique (307) a une structure d'une seule pièce.

18. Dispositif de maintien de substrat selon l'une quelconque des revendications précédentes, dans lequel la portion de contact (308) comporte une portion inclinée (308a) disposée sur un bord extérieur et inclinée vers le haut.

19. Dispositif de maintien de substrat selon l'une quelconque des revendications précédentes, dans lequel la portion inclinée (308a) a une section courbe.

20. Dispositif de maintien de substrat selon l'une quelconque des revendications 1 à 18, dans lequel la portion inclinée (308a) a une section droite.

21. Dispositif de maintien de substrat selon l'une quelconque des revendications 1 à 20, dans lequel la portion inclinée (308a) est plus mince que la portion de contact (308).

22. Dispositif de maintien de substrat selon l'une quelconque des revendications précédentes, dans lequel la portion de contact (308) comporte une portion favorisant le retrait pour favoriser le retrait de la portion de contact (308) du substrat.

23. Dispositif de maintien de substrat selon la revendication 22, dans lequel la portion favorisant le retrait comprend une encoche formée dans un bord circonférentiel de la portion de contact (308).

24. Dispositif de maintien de substrat selon la revendication 22 ou 23, dans lequel la portion de contact (308) comporte une région en un matériau ayant une adhérence au substrat plus faible que celle de la membrane élastique (307).

25. Dispositif de maintien de substrat selon l'une quelconque des revendications 22 à 24, dans lequel une surface de la portion de contact (308) comporte une pluralité de convexités et de concavités.

26. Dispositif de maintien de substrat selon la revendication 22, dans lequel la membrane élastique (307) comprend une pluralité de portions de contact (308), et la portion favorisant le retrait comprend une portion d'interconnexion pour interconnecter l'une de la pluralité de portions de contact et une autre de la pluralité de portions de contact.

27. Dispositif de maintien de substrat selon la revendication 22, dans lequel la portion favorisant le retrait comprend un renfoncement à concavité orientée vers le haut formé dans la portion de contact (308), et le renfoncement est amené en contact intime avec le substrat lorsqu'un fluide sous pression est fourni à la chambre de pression.

28. Dispositif de polissage comprenant :
un dispositif de maintien de substrat (301) selon l'une quelconque des revendications 1 à 27 ; et
une table de polissage (100) comportant une surface de polissage (101a).

29. Procédé pour polir un substrat, comprenant :
maintenir le substrat par un dispositif de maintien de substrat selon l'une quelconque des revendications 1 à 27 ;
placer le substrat sur une surface de polissage d'une table de polissage ;
déplacer l'élément mobile verticalement vers le bas pour presser la portion de contact contre le substrat ;
fournir un fluide sous pression à la chambre de pression tout en pressant la portion de contact contre le substrat ; et
amener le substrat en contact glissant avec la surface de polissage de façon à polir le substrat.
